(19) Europäisches Patentamt
European Patent Office
Office européen des brevets

(11) EP 2 978 030 A1

(12) **EUROPEAN PATENT APPLICATION**
published in accordance with Art. 153(4) EPC

(43) Date of publication:
**27.01.2016 Bulletin 2016/04**

(21) Application number: **14769181.0**

(22) Date of filing: **10.03.2014**

(51) Int Cl.:
***H01L 33/56** (2010.01)*

(86) International application number:
**PCT/JP2014/056101**

(87) International publication number:
**WO 2014/148286 (25.09.2014 Gazette 2014/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **22.03.2013 JP 2013060798**
**11.07.2013 JP 2013145375**

(71) Applicant: **Nitto Denko Corporation**
**Ibaraki-shi, Osaka 567-8680 (JP)**

(72) Inventors:
- **NINOMIYA, Akito**
  **Ibaraki-shi**
  **Osaka 567-8680 (JP)**
- **ITO, Hisataka**
  **Ibaraki-shi**
  **Osaka 567-8680 (JP)**
- **OOYABU, Yasunari**
  **Ibaraki-shi**
  **Osaka 567-8680 (JP)**
- **UMETANI, Shigehiro**
  **Ibaraki-shi**
  **Osaka 567-8680 (JP)**
- **MITANI, Munehisa**
  **Ibaraki-shi**
  **Osaka 567-8680 (JP)**

(74) Representative: **Hoffmann Eitle**
**Patent- und Rechtsanwälte PartmbB**
**Arabellastraße 30**
**81925 München (DE)**

# (54) OPTICAL SEMICONDUCTOR DEVICE MANUFACTURING METHOD

(57) A method for producing an LED device 5 producing an LED device 5 by encapsulating an LED 4 by an encapsulating sheet 1 includes a sheet producing step of producing the encapsulating sheet 1 and an encapsulating step of encapsulating the LED 4 by the encapsulating sheet 1. Time T from producing the encapsulating sheet 1 in the sheet producing step to encapsulating the LED 4 by the encapsulating sheet 1 in the encapsulating step is 24 hours or less.

FIG. 2

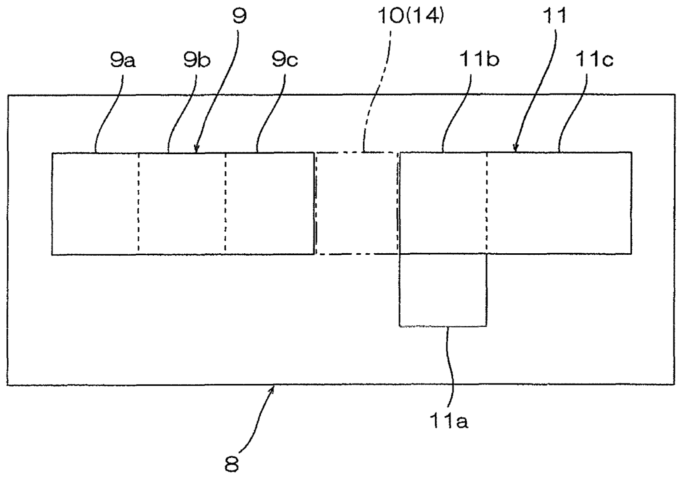


EP 2 978 030 A1

## Description

TECHNICAL FIELD

The present invention relates to a method for producing an optical semiconductor device.

BACKGROUND ART

A method for producing an optical semiconductor device by encapsulating an optical semiconductor element by an encapsulating sheet has been known.

For example, a method for producing an optical semiconductor device has been proposed (ref: for example, the following Patent Document 1). In the method, a sheet for optical-semiconductor element encapsulation that includes an encapsulating resin layer capable of encapsulating an optical semiconductor element is produced. Then, the sheet for optical-semiconductor element encapsulation is disposed in opposed relation to an optical semiconductor element-mounted board to be pressed with a pressing machine, thereby producing the optical semiconductor device.

Citation List

Patent Document

Patent Document 1: Japanese Unexamined Patent Publication No. 2011-159874

SUMMARY OF THE INVENTION

PROBLEM TO BE SOLVED BY THE INVENTION

However, to produce the optical semiconductor element-mounted board, first, a sheet for optical-semiconductor element encapsulation before a C-stage state is produced and then, the sheet for optical-semiconductor element encapsulation is sent and transported. Then, after the sheet for optical-semiconductor element encapsulation is preserved (stored) at the destination, it is provided in a pressing machine on which the optical semiconductor element-mounted board is disposed. Thereafter, by pressing, the optical semiconductor element mounted on the optical semiconductor element-mounted board is embedded by the sheet for optical-semiconductor element encapsulation, and the sheet for optical-semiconductor element encapsulation is brought into a C-stage state. In this manner, the optical semiconductor element is encapsulated by the sheet for optical-semiconductor element encapsulation.

Thus, the sheet for optical-semiconductor element encapsulation is required to be retained in a state before the C-stage state in which encapsulation of the optical semiconductor element is possible at the time of transportation and preservation thereof for a long period of time. Then, the sheet for optical-semiconductor element encapsulation needs to be designed and managed so that the state before the C-stage state thereof is retained for a long period of time under various environments, and thus, there is a disadvantage that its production cost and furthermore, its management cost are increased.

An object of the present invention is to provide a method for producing an optical semiconductor device that is capable of easily managing an encapsulating layer in a state before a C-stage state for encapsulating an optical semiconductor element and improving the production efficiency of an optical semiconductor device.

MEANS FOR SOLVING THE PROBLEM

A method for producing an optical semiconductor device of the present invention producing an optical semiconductor device by encapsulating an optical semiconductor element by an encapsulating layer includes an encapsulating layer producing step of producing the encapsulating layer and an encapsulating step of encapsulating the optical semiconductor element by the encapsulating layer, wherein time from producing the encapsulating layer in the encapsulating layer producing step to encapsulating the optical semiconductor element by the encapsulating layer in the encapsulating step is 24 hours or less.

According to this method, the time from producing the encapsulating layer in the encapsulating layer producing step to encapsulating the optical semiconductor element by the encapsulating layer in the encapsulating step is short, so that the production efficiency of the optical semiconductor device can be improved.

According to this method, a state before a C-stage state of the encapsulating layer is not required to be retained for a long period of time, so that the encapsulating layer in the state before the C-stage state can be easily designed and managed. Thus, a degree of freedom in design and management of the encapsulating layer in the state before the

C-stage state can be increased.

In the method for producing an optical semiconductor device of the present invention, it is preferable that the encapsulating layer produced in the encapsulating layer producing step is conveyed at room temperature to be supplied to the encapsulating step.

In a case where the conveyance and storage of the encapsulating layer requires a long period of time, the encapsulating layer in the state before the C-stage state is required to be cooled (frozen) at a lower temperature to be conveyed and stored for prevention of the encapsulating layer from the state before the C-stage state into the C-stage state.

According to this method, however, time from the state before the C-stage state to the C-stage state is short, so that the encapsulating layer in the state before the C-stage state produced in the encapsulating layer producing step can be conveyed at the room temperature to be supplied to the encapsulating step. Thus, the number of steps and equipment for the above-described cooling are unnecessary and as a result, the production cost can be reduced.

When the encapsulating layer is cooled, it is required that the cooled encapsulating layer is brought back to the room temperature and then, the optical semiconductor element is encapsulated by the encapsulating layer. When the cooled encapsulating layer is brought back to the room temperature for a short period of time, there may be a case where dew condensation occurs in the encapsulating layer and encapsulation of the optical semiconductor element by the dew-condensed encapsulating layer causes a void, thereby reducing the reliability of the optical semiconductor device.

Meanwhile, when the cooled encapsulating layer is brought back to the room temperature over a long period of time for prevention of dew condensation of the encapsulating layer, the production efficiency of the optical semiconductor device is significantly reduced.

According to this method, however, the above-described cooling is unnecessary and thus, it is unnecessary to bring the cooled encapsulating layer back to the room temperature, so that the production time can be shortened. Thus, the production cost can be reduced. Furthermore, the occurrence of a void caused by the above-described dew condensation can be prevented, so that an optical semiconductor device having excellent reliability can be produced.

In the method for producing an optical semiconductor device of the present invention producing the optical semiconductor device by encapsulating the optical semiconductor element by an encapsulating sheet in a B-stage state, it is preferable that the encapsulating layer producing step is a sheet producing step of producing the encapsulating sheet in the B-stage state; in the encapsulating step, the optical semiconductor element is encapsulated by the encapsulating sheet in the B-stage state; and time from producing the encapsulating sheet in the B-stage state in the sheet producing step to encapsulating the optical semiconductor element by the encapsulating sheet in the B-stage state in the encapsulating step is 24 hours or less.

According to this method, the time from producing the encapsulating sheet in the B-stage state in the sheet producing step to encapsulating the optical semiconductor element by the encapsulating sheet in the B-stage state in the encapsulating step is short, so that the production efficiency of the optical semiconductor device can be improved.

According to this method, the B-stage state of the encapsulating sheet is not required to be retained for a long period of time, so that the encapsulating sheet in the B-stage state can be easily designed and managed. Thus, a degree of freedom in design and management of the encapsulating sheet in the B-stage state can be increased.

Furthermore, according to this method, in the encapsulating step, the optical semiconductor element is encapsulated by the encapsulating sheet in the B-stage state, so that the optical semiconductor element can be easily encapsulated by the encapsulating sheet in the B-stage state having more excellent handleability than an encapsulating sheet in an A-stage state.

In the method for producing an optical semiconductor device of the present invention, it is preferable that the encapsulating sheet in the B-stage state produced in the sheet producing step has a compressive elastic modulus at 25°C of 0.040 MPa or more and 0.145 MPa or less.

According to this method, a usable range of the compressive elastic modulus of the encapsulating sheet in the B-stage state is wide, so that a degree of freedom in design of the encapsulating sheet in the B-stage state can be further increased.

In the method for producing an optical semiconductor device of the present invention, it is preferable that an increase amount of the compressive elastic modulus at 25°C at the time of preserving the encapsulating sheet in the B-stage state produced in the sheet producing step at 25°C for 24 hours is 0.015 MPa or more and 0.120 MPa or less.

According to this method, the optical semiconductor element can be encapsulated by the encapsulating sheet in the B-stage state having a large increase amount of the compressive elastic modulus at 25°C at the time of being preserved at 25°C for 24 hours. That is, by using a fast curable type encapsulating sheet in a B-stage state, time required for C-stage conversion can be shortened. Thus, the production time of the optical semiconductor device can be shortened and as a result, the production cost can be reduced.

In the method for producing an optical semiconductor device of the present invention producing the optical semiconductor device by encapsulating the optical semiconductor element by an encapsulating layer in an A-stage state, it is preferable that in the encapsulating layer producing step, the encapsulating layer in the A-stage state is

produced; in the encapsulating step, the optical semiconductor element is encapsulated by the encapsulating layer in the A-stage state; and time from producing the encapsulating layer in the A-stage state in the encapsulating layer producing step to encapsulating the optical semiconductor element by the encapsulating layer in the A-stage state in the encapsulating step is 24 hours or less.

According to this method, the time from producing the encapsulating layer in the A-stage state in the encapsulating layer producing step to encapsulating the optical semiconductor element by the encapsulating layer in the A-stage state in the encapsulating step is short, so that the production efficiency of the optical semiconductor device can be improved.

According to this method, the A-stage state of the encapsulating layer is not required to be retained for a long period of time, so that the encapsulating layer in the A-stage state can be easily designed and managed. Thus, a degree of freedom in design and management of the encapsulating layer in the A-stage state can be increased.

Furthermore, according to this method, in the encapsulating layer producing step, the encapsulating layer in the A-stage state is produced and in the encapsulating step, the optical semiconductor element is encapsulated by the encapsulating layer, so that the number of steps of preparing an encapsulating layer in a B-stage state can be reduced. Thus, the number of steps can be reduced and the production efficiency of the optical semiconductor device can be improved.

## EFFECT OF THE INVENTION

According to the present invention, the production efficiency of the optical semiconductor device can be improved. Also, a degree of freedom in design and management of the encapsulating layer can be increased.

## BRIEF DESCRIPTION OF THE DRAWINGS

[FIG. 1] FIG. 1 shows a flow chart of a method for producing an LED device that is a first embodiment of a method for producing an optical semiconductor device of the present invention.
[FIG. 2] FIG. 2 shows a schematic view of an LED device producing factory in which each of the steps shown in FIG. 1 is performed.
[FIG. 3] FIGS. 3A to 3C show each of the devices in a sheet producing area in which a sheet producing step is performed:
FIG. 3A illustrating a mixture vessel in a varnish preparing area,
FIG. 3B illustrating a dispenser in an application area, and
FIG. 3C illustrating an oven in a B-stage conversion area.
[FIG. 4] FIGS. 4A to 4C show racks used in a conveying step:
FIG. 4A illustrating a state in which the entire shelf boards are flipped up,
FIG. 4B illustrating a state in which a part of the shelf boards are lowered and an encapsulating sheet is disposed, and
FIG. 4C illustrating a state in which the entire shelf boards are lowered and the encapsulating sheets are disposed.
[FIG. 5] FIG. 5 shows a magazine used in a conveying step.
[FIG. 6] FIG. 6 shows a lid-including vessel used in a conveying step.
[FIG. 7] FIG. 7 shows a roll including a separator used in a conveying step.
[FIG. 8] FIG. 8 shows a roll including spacers used in a conveying step.
[FIG. 9] FIG. 9 shows a pressing machine used in an encapsulating step.
[FIG. 10] FIG. 10 shows an LED device.
[FIG. 11] FIG. 11 shows a relationship between a surface temperature of an encapsulating sheet and an elapsed time after disposing a lid-including vessel on a stainless steel stand.
[FIG. 12] FIG. 12 shows a schematic side view of an encapsulating sheet producing unit used in a modified example of the method for producing an LED device of the first embodiment.
[FIG. 13] FIG. 13 shows a flow chart of a method for producing an LED device that is a second embodiment of a method for producing an optical semiconductor device of the present invention.
[FIG. 14] FIG. 14 shows a schematic view of an LED device producing factory in which each of the steps shown in FIG. 13 is performed.
[FIG. 15] FIG. 15 shows a laminating device used in an encapsulating step.
[FIG. 16] FIG. 16 shows an LED device.

DESCRIPTION OF EMBODIMENTS

<First Embodiment>

A method for producing an LED device 5 that is a first embodiment of a method for producing an optical semiconductor device of the present invention is described with reference to FIGS. 1 to 10.

As referred to FIG. 10, in the method for producing the LED device 5, the LED device 5 is produced by encapsulating an LED 4 as an optical semiconductor element by an encapsulating sheet 1 in a B-stage state as an encapsulating layer. As shown in FIG. 1, the method for producing the LED device 5 includes a sheet producing step (one example of an encapsulating layer producing step) of producing the encapsulating sheet 1 in the B-stage state as the encapsulating layer and an encapsulating step of encapsulating the LED 4 by the encapsulating sheet 1. The method for producing the LED device 5 includes a conveying step of conveying the encapsulating sheet 1 produced in the sheet producing step to the encapsulating step. In a method for producing the LED 4, a sheet producing step, a conveying step, and an encapsulating step are sequentially performed.

As shown in FIG. 2, the method for producing the LED device 5 is performed in an LED device producing factory 8. The LED device producing factory 8 includes a sheet producing area 9, a conveying area 10, and an encapsulating area 11.

The above-described entire areas (the sheet producing area 9, the conveying area 10, and the encapsulating area 11) are, for example, provided in the site of the same factory, that is, in one (same) LED device producing factory 8.

In the following, each of the steps and each of the areas are described in detail.

<Sheet Producing Step>

The sheet producing step is performed in the sheet producing area 9.

The sheet producing area 9 includes a varnish preparing area 9a, an application area 9b, and a B-stage conversion area 9c.

In the sheet producing step, to produce the encapsulating sheet 1 in the B-stage state, first, for example, an encapsulating resin composition is prepared in the varnish preparing area 9a.

The encapsulating resin composition contains a two-step curable type resin. The encapsulating resin composition preferably consists of the two-step curable type resin.

The two-step curable type resin is a curable type resin which has a two-step reaction mechanism and in which in a first-step reaction, the resin is brought into a B-stage (semi-cured) state and in a second-step reaction, the resin is brought into a C-stage (completely cured) state.

The B-stage state is a state between an A-stage state in which the two-step curable type resin is liquid and a C-stage state in which the two-step curable type resin is completely cured. The B-stage state is a state in which curing and gelation slightly progress and the compressive elastic modulus is smaller than the elastic modulus in the C-stage state.

Examples of the two-step curable type resin include a two-step curable type thermosetting resin that cures by heating and a two-step curable type active energy ray curable type resin that cures by application of active energy rays (e.g., ultraviolet rays, electron rays, etc.). Preferably, a two-step curable type thermosetting resin is used.

To be specific, examples of the two-step curable type thermosetting resin include silicone resin, epoxy resin, polyimide resin, phenol resin, urea resin, melamine resin, and unsaturated polyester resin. Preferably, in view of light transmittance and durability, a two-step curable type silicone resin is used.

An example of the two-step curable type silicone resin includes a condensation reaction and addition reaction curable type silicone resin having two reaction systems of condensation reaction and addition reaction.

Examples of the condensation reaction and addition reaction curable type silicone resin include a first condensation reaction and addition reaction curable type silicone resin that contains a polysiloxane containing silanol groups at both ends, an alkenyl group-containing trialkoxysilane, an organohydrogenpolysiloxane, a condensation catalyst, and a hydrosilylation catalyst; a second condensation reaction and addition reaction curable type silicone resin that contains a polysiloxane containing silanol groups at both ends (ref: formula (1) to be described later), an ethylenically unsaturated hydrocarbon group-containing silicon compound (ref: formula (2) to be described later), an ethylenically unsaturated hydrocarbon group-containing silicon compound (ref: formula (3) to be described later), an organohydrogenpolysiloxane, a condensation catalyst, and a hydrosilylation catalyst; a third condensation reaction and addition reaction curable type silicone resin that contains a silicone oil containing silanol groups at both ends, an alkenyl group-containing dialkoxyalkylsilane, an organohydrogenpolysiloxane, a condensation catalyst, and a hydrosilylation catalyst; a fourth condensation reaction and addition reaction curable type silicone resin that contains an organopolysiloxane having in one molecule at least two alkenylsilyl groups, an organopolysiloxane having in one molecule at least two hydrosilyl groups, a hydrosilylation catalyst, and a curing retarder; a fifth condensation reaction and addition reaction curable type silicone resin that contains a first organopolysiloxane having in one molecule both at least two ethylenically unsaturated hydrocarbon groups and at least two hydrosilyl groups, a second organopolysiloxane having in one molecule at least two hydrosilyl groups without containing an ethylenically unsaturated hydrocarbon group, a hydrosilylation catalyst, and a hydrosilylation retarder; a sixth condensation reaction and addition reaction curable type silicone resin that contains a first organopolysiloxane having in one molecule both at least two ethylenically unsaturated hydrocarbon groups and at least two silanol groups, a second organopolysiloxane having in one molecule at least two hydrosilyl groups without containing an ethylenically unsaturated hydrocarbon group, a hydrosilylation retarder, and a hydrosilylation catalyst; a seventh condensation reaction and addition reaction curable type silicone resin that contains a silicon compound, and a boron compound or an aluminum compound; and an eighth condensation reaction and addition reaction curable type silicone resin that contains a polyaluminosiloxane and a silane coupling agent.

As the condensation reaction and addition reaction curable type silicone resin, preferably, a second condensation reaction and addition reaction curable type silicone resin is used. To be specific, the second condensation reaction and addition reaction curable type silicone resin is described in Japanese Unexamined Patent Publication No. 2010-265436 or the like and contains, for example, a polydimethylsiloxane containing silanol groups at both ends, a vinyltrimethoxysilane, a (3-glycidoxypropyl)trimethoxysilane, a dimethylpolysiloxane-co-methylhydrogenpolysiloxane, a tetramethylammonium hydroxide, and a platinum-carbonyl complex. To be specific, the second condensation reaction and addition reaction curable type silicone resin is prepared as follows: for example, first, an ethylenically unsaturated hydrocarbon group-containing silicon compound and an ethylenically unsaturated hydrocarbon group-containing silicon compound, which are a condensation material, and a condensation catalyst are simultaneously added; next, an organohydrogenpolysiloxane, which is an addition material, is added thereto; and thereafter, a hydrosilylation catalyst (addition catalyst) is added thereto.

The condensation catalyst content with respect to 100 parts by mass of the condensation material is, for example, $1 \times 10^{-5}$ parts by mass or more, preferably $1 \times 10^{-4}$ parts by mass or more, and for example, 50 parts by mass or less, preferably 10 parts by mass or less.

By selecting the condensation catalyst content from the above-described range, a desired compressive elastic modulus M0 (described later) at 25°C of the encapsulating sheet 1 (ref: FIG. 3C) produced in the sheet producing step can be set from a wide range.

The mixing ratio of the two-step curable type resin with respect to the encapsulating resin composition is, for example, 30 mass% or more, preferably 40 mass% or more, more preferably 50 mass% or more, and for example, 98 mass% or less, preferably 95 mass% or less, more preferably 90 mass% or less.

The encapsulating resin composition can also contain, if necessary, a phosphor and/or a filler.

The phosphor has a wavelength conversion function. Examples of the phosphor include a yellow phosphor that is capable of converting blue light into yellow light and a red phosphor that is capable of converting blue light into red light.

Examples of the yellow phosphor include silicate phosphors such as $(Ba, Sr, Ca)_2SiO_4$:Eu and $(Sr, Ba)_2SiO_4$:Eu (barium orthosilicate (BOS)); garnet-type phosphors having a garnet-type crystal structure such as $Y_3Al_5O_{12}$:Ce (YAG (yttrium aluminum garnet):Ce) and $Tb_3Al_3O_{12}$:Ce (TAG (terbium aluminum garnet):Ce); and oxynitride phosphors such as Ca-$\alpha$-SiAlON.

Examples of the red phosphor include nitride phosphors such as $CaAlSiN_3$:Eu and $CaSiN_2$:Eu.

Examples of a shape of the phosphor include a sphere shape, a plate shape, and a needle shape. Preferably, in view of fluidity, a sphere shape is used.

The phosphor has an average value of the maximum length (in the case of the sphere shape, an average particle size) of, for example, 0.1 $\mu$m or more, preferably 1 $\mu$m or more, and for example, 200 $\mu$m or less, preferably 100 $\mu$m or less.

These phosphors can be used alone or in combination of two or more.

The mixing ratio of the phosphor with respect to 100 parts by mass of the two-step curable type resin is, for example, 0.1 parts by mass or more, preferably 0.5 parts by mass or more, and for example, 80 parts by mass or less, preferably 50 parts by mass or less.

A filler is blended in the encapsulating resin composition so as to improve toughness of the encapsulating sheet 1 (ref: FIG. 3C). Examples of the filler include organic microparticles such as silicone particles (to be specific, including silicone rubber particles) and inorganic microparticles such as silica (e.g., fumed silica etc.), talc, alumina, aluminum nitride, and silicon nitride. The filler has an average value of the maximum length (in the case of the sphere shape, an average particle size) of, for example, 0.1 $\mu$m or more, preferably 1 $\mu$m or more, and for example, 200 $\mu$m or less, preferably 100 $\mu$m or less. These fillers can be used alone or in combination of two or more. The mixing ratio of the filler with respect to 100 parts by mass of the two-step curable type resin is, for example, 0.1 parts by mass or more, preferably 0.5 parts by mass or more, and for example, 70 parts by mass or less, preferably 50 parts by mass or less.

To prepare the encapsulating resin composition, the two-step curable type resin, and the phosphor and/or the filler, which are blended as needed, are blended and mixed. In addition to the above-described components, a solvent can be blended at an appropriate proportion. Examples of the solvent include aliphatic hydrocarbons such as hexane;

aromatic hydrocarbons such as xylene; and siloxanes such as vinyl methyl cyclic siloxane and both terminal vinyl polydimethylsiloxane.

To be specific, as shown in FIG. 3A, to prepare the encapsulating resin composition, in the varnish preparing area 9a, the above-described components are blended in a mixture vessel 52 having a stirrer 51 to be subsequently mixed using the stirrer 51.

To be more specific, the two-step curable type resin in the A-stage state, the phosphor and/or the filler, and if necessary, the solvent are blended and mixed. In this manner, the encapsulating resin composition in the A-stage state is prepared as a varnish.

The varnish has a viscosity under the conditions of 25°C and 1 atmospheric pressure of, for example, 1,000 mPa·s or more, preferably 4,000 mPa·s or more, and for example, 1,000,000 mPa·s or less, preferably 100,000 mPa·s or less. The viscosity is measured by adjusting the temperature of the varnish to 25°C at number of revolutions of $99s^{-1}$ using an E-type cone. The following viscosity is measured in the same manner as that described above.

Next, in this method, the encapsulating resin composition (varnish) in the A-stage state is applied in the application area 9b shown in FIG. 2.

To be specific, as shown in FIG. 3B, the varnish is applied to a surface of a release sheet 2.

Examples of the release sheet 2 include polymer films such as a polyethylene film and a polyester film (PET etc.); ceramics sheets; and metal foils. Preferably, a polymer film is used. The surface of the release sheet 2 may be subjected to release treatment such as fluorine treatment. The shape of the release sheet 2 is not particularly limited and the release sheet 2 can be, for example, formed into a generally rectangular shape (including a strip shape and a long-length shape) in plane view.

To apply the varnish to the surface of the release sheet 2, for example, application devices such as a dispenser, an applicator, and a slit die coater are used. Preferably, a dispenser 13 shown in FIG. 3B is used.

The varnish is applied to the release sheet 2 so that in a next B-stage conversion step, the encapsulating sheet 1 has a thickness of, for example, 10 μm or more, preferably 50 μm or more, and for example, 2000 μm or less, preferably 1000 μm or less.

The varnish is, in plane view, applied in an appropriate shape such as a generally rectangular shape (including a strip shape and a long-length shape) and a circular shape. The varnishes having the above-described shape may be formed at spaced intervals to each other.

The varnish can be, for example, applied to the release sheet 2 in a generally rectangular shape (excluding a long-length shape) in plane view to form a single sheet type encapsulating sheet 1 by the B-stage conversion step to be described next, or can be continuously applied to the long-length release sheet 2 to form a continuous type encapsulating sheet 1 by the B-stage conversion step to be described next. Preferably, the varnish is applied to the release sheet 2 to form a single sheet type encapsulating sheet 1. When the encapsulating sheet 1 is formed in a single sheet type and a plurality of encapsulating sheets 1 are produced in the same release sheet 2, the varnish is intermittently applied.

Thereafter, the applied varnish is brought into a B-stage state (semi-cured) in the B-stage conversion area 9c shown in FIG. 2.

When the varnish contains a two-step curable type thermosetting resin, for example, the applied varnish is heated.

To heat the varnish, for example, as shown in FIG. 3C, an oven 55 having a heater 54 that is disposed in opposed relation to the upper side and/or the lower side of the release sheet 2 is used.

The heating conditions are as follows: a heating temperature of, for example, 40°C or more, preferably 80°C or more, more preferably 100°C or more, and for example, 200°C or less, preferably 150°C or less, more preferably 140°C or less and a heating time of, for example, 1 minute or more, preferably 5 minutes or more, more preferably 10 minutes or more, and for example, 24 hours or less, preferably 1 hour or less, more preferably 0.5 hours or less.

By selecting the heating conditions from the above-described range, the desired compressive elastic modulus M0 (described later) at 25°C of the encapsulating sheet 1 produced in the sheet producing step can be set from a wide range.

Or, when the varnish contains a two-step curable type active energy ray curable type resin, an active energy ray is applied to the varnish.

In this manner, the varnish is brought into a B-stage state (semi-cured), but is not brought into a C-stage state (completely cured). That is, the encapsulating sheet 1 before the C-stage conversion (completely curing), i.e., the encapsulating sheet 1 in the B-stage state is formed.

The C-stage conversion refers to a state having a cure degree of 90% or more. The cure degree is calculated as follows: a state in which a compressive elastic modulus increase is saturated by, for example, heating or application of the active energy ray is defined as the cure degree of 100% and from the obtained value, the ratio (the ratio of the compressive elastic modulus of a measurement sample to the saturated compressive elastic modulus) of the compressive elastic modulus is calculated.

In this manner, as shown in FIG. 3C, the encapsulating sheet 1 in the B-stage state laminated on the surface of the release sheet 2 is produced in the sheet producing area 9 in FIG. 2.

The encapsulating sheet 1 produced in the sheet producing step has the compressive elastic modulus M0 at 25°C of, for example, 0.040 MPa or more, preferably 0.050 MPa or more, more preferably 0.075 MPa or more, further more preferably 0.100 MPa or more, and for example, 0.145 MPa or less, preferably 0.140 MPa or less, more preferably 0.135 MPa or less, further more preferably 0.125 MPa or less.

When the compressive elastic modulus M0 is above the above-described upper limit, the upper limit of the desired compressive elastic modulus (for example, a compressive elastic modulus M2 of the encapsulating sheet 1 at the time of encapsulating the LED 4 by the encapsulating sheet 1 in the encapsulating step after 24 hours of production of the encapsulating sheet 1 in the B-stage state in the sheet producing step to be described later) may be exceeded at the time of encapsulating the LED 4 by the encapsulating sheet 1. In such a case, when the LED 4 is wire-bonding connected to a board 6 (ref: dashed line in FIG. 9), a wire 7 may be deformed.

Meanwhile, when the compressive elastic modulus M0 is below the above-described lower limit, it is difficult to ensure the shape of the encapsulating sheet 1. That is, the vanish may fail to form the shape of the encapsulating sheet 1.

To be more specific, to produce the encapsulating sheet 1 having the compressive elastic modulus M0 at 25°C of, for example, 0.040 MPa or more and less than 0.100 MPa in the sheet producing step, for example, when the two-step curable type resin is a condensation reaction and addition reaction curable type silicone resin (to be specific, the first to third condensation reaction and addition reaction curable type silicone resin), the condensation catalyst content with respect to 100 parts by mass of the condensation material is set to be, for example, $1 \times 10^{-5}$ parts by mass or more, preferably $1 \times 10^{-4}$ parts by mass or more; or when the heating temperature is set to be, for example, 80°C or more, furthermore 100°C or more, and for example, 180°C or less, furthermore 150°C or less, the heating time is set to be, for example, 60 minutes or less, preferably 40 minutes or less, more preferably 30 minutes or less, and for example, 5 minutes or more.

Also, to produce the encapsulating sheet 1 having the compressive elastic modulus M0 at 25°C of, for example, 0.100 MPa or more and less than 0.145 MPa in the sheet producing step, for example, when the two-step curable type resin is a condensation reaction and addition reaction curable type silicone resin (to be specific, the first to third condensation reaction and addition reaction curable type silicone resin), the condensation catalyst content with respect to 100 parts by mass of the condensation material is set to be, for example, $1 \times 10^{-5}$ parts by mass or more, preferably $1 \times 10^{-4}$ parts by mass or more; or when the heating temperature is set to be, for example, 80°C or more, furthermore 100°C or more, and for example, 180°C or less, furthermore 150°C or less, the heating time is set to be, for example, 90 minutes or less, preferably 60 minutes or less, more preferably 45 minutes or less, and for example, 7.5 minutes or more.

An increase amount $\Delta M$ of the compressive elastic modulus at 25°C when the encapsulating sheet 1 produced in the sheet producing step is preserved at 25°C for 24 hours is, for example, 0 MPa or more, preferably 0.015 MPa or more, and for example, 0.120 MPa or less.

The increase amount $\Delta M$ is a value (M2 - M0) obtained by deducting the compressive elastic modulus M0 before preserving the encapsulating sheet 1 produced in the sheet producing step at 25°C for 24 hours, that is, the compressive elastic modulus M0 at 25°C of the encapsulating sheet 1 produced in the sheet producing step from a compressive elastic modulus M2 after preserving the encapsulating sheet 1 produced in the sheet producing step at 25°C for 24 hours.

When the increase amount $\Delta M$ is below the above-described lower limit, the state conversion from the B-stage state to the C-stage state of the encapsulating sheet 1 is excessively slow. Thus, the time for converting the encapsulating sheet 1 into the C-stage state may be an excessively long period of time. As a result, the production efficiency of the LED device 5 (ref: FIG. 10) may be reduced.

Meanwhile, when the increase amount $\Delta M$ is above the above-described upper limit, the state conversion from the B-stage state to the C-stage state of the encapsulating sheet 1 is excessively fast. Thus, though described later, during the time between production of the encapsulating sheet 1 in the sheet producing step and encapsulation of the LED 4 by the encapsulating sheet 1 in the encapsulating step, the encapsulating sheet 1 in the B-stage state is converted into that in the C-stage state. As a result, when the LED 4 is wire-bonding connected to the board 6, there may be a case where the wire 7 is deformed or the encapsulating sheet 1 cannot surely encapsulate the LED 4.

To be more specific, the encapsulating sheet 1 produced in the sheet producing step serves as a short-time curable type (that is, fast curable type) encapsulating sheet 1 having a relatively short period of time for C-stage conversion so that the increase amount $\Delta M$ of the compressive elastic modulus at 25°C when the encapsulating sheet 1 is preserved at 25°C for 24 hours is, for example, 0.050 MPa or more (furthermore, 0.075 MPa or more, furthermore, 0.100 MPa or more), and for example, 0.120 MPa or less. To obtain the fast curable type encapsulating sheet 1, for example, when the two-step curable type resin is a condensation reaction and addition reaction curable type silicone resin (to be specific, the first to third condensation reaction and addition reaction curable type silicone resin), the hydrosilylation catalyst content with respect to 100 parts by mass of the addition material is, for example, $5.6 \times 10^{-3}$ parts by mass or more, preferably 0.01 parts by mass or more.

Meanwhile, the encapsulating sheet 1 produced in the sheet producing step serves as a long-time curable type (that is, slow curable type) encapsulating sheet 1 having a relatively long period of time for C-stage conversion so that the increase amount ΔM of the compressive elastic modulus at 25°C when the encapsulating sheet 1 is preserved at 25°C for 24 hours is, for example, 0.015 MPa or more, and for example, less than 0.050 MPa. To obtain the slow curable type encapsulating sheet 1, for example, when the two-step curable type resin is a condensation reaction and addition reaction curable type silicone resin (to be specific, the first to third condensation reaction and addition reaction curable type silicone resin), the hydrosilylation catalyst content with respect to 100 parts by mass of the addition material is, for example, $1 \times 10^{-3}$ parts by mass or more, preferably $5 \times 10^{-4}$ parts by mass or more.

Thereafter, in the sheet producing area 9 in FIG. 2, if necessary, the continuous type encapsulating sheet 1 in the B-stage state, along with the release sheet 2 to be continuous thereto, can be cut into a predetermined shape to form the single sheet type encapsulating sheet 1.

<Conveying Step>

As shown in FIG. 2, the conveying step is performed in the conveying area 10. The conveying area 10 is provided between the sheet producing area 9 and the encapsulating area 11.

In the conveying step, in the sheet producing area 9, the encapsulating sheet 1 produced in the sheet producing step is conveyed at room temperature to be supplied to the encapsulating area 11 in which the encapsulating step is performed. Or, the encapsulating sheet 1 is conveyed at a lower temperature of less than the room temperature.

The room temperature is a temperature that is not a temperature retained at a lower temperature so as to actively cool the encapsulating sheet 1 with, for example, a special cooling unit such as a freezer and a refrigerator, while including a temperature that is appropriately cooled so as to adjust the working environment with, for example, an air conditioner. To be specific, the room temperature is, for example, 10°C or more, furthermore 20°C or more, furthermore, 23°C or more, and for example, 40°C or less, furthermore 30°C or less, furthermore 25°C or less.

The lower temperature of less than the room temperature is a temperature that is retained at a lower temperature so as to cool the encapsulating sheet 1 with a special cooling unit. To be specific, the lower temperature of less than the room temperature is, for example, less than 10°C, furthermore 5°C or less, and for example, -60°C or more.

Preferably, the encapsulating sheet 1 produced in the sheet producing step is conveyed at the room temperature. When the encapsulating sheet 1 is conveyed at the room temperature, the above-described cooling unit for cooling is unnecessary and thus, the production unit of the LED device 5 can be simplified. As a result, the production cost of the LED device 5 can be reduced.

To convey the encapsulating sheet 1, when the encapsulating sheet 1 in a single sheet type is produced, for example, it is housed in a conveying vessel such as a rack 15 shown in FIGS. 4A to 4C, a magazine 16 shown in FIG. 5, and a lid-including vessel 17 shown in FIG. 6. Then, the conveying vessel is conveyed to a pressing machine 20 (described later, ref: FIG. 9) in the encapsulating step.

When the encapsulating sheet 1 in a continuous type is produced, as shown in FIG. 7, the release sheet 2 is formed into a long-length shape. A separator 18 is laminated on a surface (opposite surface to a contact surface with respect to the release sheet 2) of the encapsulating sheet 1. Then, the release sheet 2, the encapsulating sheet 1, and the separator 18 are wound around to form a roll 22. In this way, the encapsulating sheet 1, as the roll 22, can be conveyed to the pressing machine 20 (described later, ref: FIG. 9).

Or, when the encapsulating sheet 1 in a continuous type is produced, as shown in FIG. 8, in the long-length release sheet 2, long-length spacers 12 are provided at both outer sides in a widthwise direction (direction orthogonal to a long-length direction and a thickness direction) of the encapsulating sheet 1. Subsequently, the release sheet 2, the encapsulating sheet 1, and the spacers 12 are wound around so that the surface of the encapsulating sheet 1 is not in contact with the rear surface of the release sheet 2. In this way, the roll 22 is formed, and the encapsulating sheet 1, as the roll 22, can be conveyed to the pressing machine 20 (described later, ref: FIG. 9).

Furthermore, when the encapsulating sheet 1 in a continuous type is produced, to supply the encapsulating sheet 1 to the encapsulating area 11, the encapsulating sheet 1 can be also continuously conveyed to the encapsulating area 11 with, for example, a conveyor 14 shown by phantom lines in FIG. 2.

Of the above-described conveying vessels, preferably, in view of surely preventing the contact of the encapsulating sheet 1 with another member, the rack 15 shown in FIGS. 4A to 4C, the magazine 16 shown in FIG. 5, and the lid-including vessel 17 shown in FIG. 6 are used. That is, the conveying vessel that conveys the single sheet type encapsulating sheet 1 is used.

As shown in FIGS. 4A to 4C, the rack 15 includes a frame 30 in a generally L-shape in side sectional view, a plurality of shelf boards 31 provided in the frame 30 rotatably in un up-down direction, and casters 32 provided in the frame 30.

The frame 30 integrally includes a bottom frame 33 formed into a generally rectangular frame shape in plane view and a back frame 34 extending from the rear end portion of the bottom frame 33 upwardly.

The plurality of shelf boards 31 are provided at spaced intervals to each other in the up-down direction. The shelf boards 31 are formed into a net rack shape. The rear end portions thereof are rotatably supported by the back frame 34 to be capable of flipping up. In the front end portions of the shelf boards 31, retaining pieces 35, which protrude downwardly, are provided. To be specific, the shelf boards 31 are configured, when the front end portions thereof are lowered, to allow the retaining pieces 35 to retain a horizontal position of the shelf boards 31. As shown in FIG. 4A, when the encapsulating sheet 1 is not disposed, the shelf boards 31 are flipped up to be disposed in an inclined state. Meanwhile, as shown in FIGS. 4B and 4C, when the encapsulating sheet 1 is disposed, the shelf boards 31, which are adjacent to each other in the up-down direction, are not in contact with each other, and in this manner, a housing space is formed between the shelf boards 31. Also, the shelf boards 31 retain a horizontal position.

The plurality of casters 32 are provided on the lower surface of the bottom frame 33.

To house the encapsulating sheet 1 in the rack 15, first, the front end portion of the flipped shelf board 31 (for example, the lowermost positioned shelf board 31) shown in FIG. 4A is, as shown by an arrow in FIG. 4B, lowered to be horizontal. Next, the encapsulating sheet 1 is disposed over the shelf board 31. To be specific, the encapsulating sheet 1 is disposed so that the release sheet 2 is in contact with the upper surface of the shelf board 31.

To house the plurality of encapsulating sheets 1 in the rack 15, as shown in FIG. 4B, the shelf board 31, which is disposed in adjacent to the upper side of the lowermost shelf board 31 on which the encapsulating sheet 1 is disposed, is allowed to be horizontal. Then, the encapsulating sheet 1 is disposed over the shelf board 31. This action is repeated. In this manner, as shown in FIG. 4C, the encapsulating sheet 1 is disposed in each of the entire shelf boards 31. In this manner, the plurality of encapsulating sheets 1 are housed in the rack 15.

Thereafter, the rack 15 is conveyed to the encapsulating area 11 shown in FIG. 2 using the casters 32.

The rack 15 is versatile. Furthermore, when the encapsulating sheet 1 is not housed in the rack 15, the rack 15 can be compactly stored, so that space saving can be achieved.

The magazine 16 shown in FIG. 5 is a rack including a case 36 in a generally box shape having an opening forwardly and disposing plates 37 provided in the case 36.

The disposing plates 37 are a supporting plate on which the circumferential end portion of the encapsulating sheet 1 (release sheet 2) is disposed. The plurality of disposing plates 37 are provided in alignment at spaced intervals to each other in the up-down direction in the case 36. Each of the disposing plates 37 is, as shown by the phantom lines, formed into a generally flat plate shape or, as shown by solid lines, formed into a generally U-shape in plane view having an opening forwardly (solid lines, however, the U-shape is not shown in FIG. 5).

To house the encapsulating sheet 1 in the magazine 16, the release sheet 2 is disposed on the upper surface of the disposing plate 37.

Thereafter, the magazine 16 is conveyed to the encapsulating area 11 shown in FIG. 2.

The lid-including vessel 17 shown in FIG. 6 includes a tray 40 and a cover (upper lid) 41.

The tray 40 is formed from a resin such as PET into a thin plate shape. The tray 40 integrally includes a tray brim portion 42, a tray flat plate portion 43, and a tray frame portion 44.

The tray brim portion 42 is formed into a generally frame shape in plane view in the circumferential end portion of the tray 40.

The tray flat plate portion 43 forms the inner-side portion of the tray 40 and is formed into a flat plate shape that is disposed at the inner side of the tray 40, compared to the inner circumferential end of the tray brim portion 42.

The tray frame portion 44 is formed so as to connect the inner circumferential end of the tray frame portion 44 to the outer circumferential end of the tray flat plate portion 43 and to protrude upwardly.

The cover 41 integrally includes a cover brim portion 45 and a cover flat plate portion 46.

The cover brim portion 45 is formed into a generally frame shape in plane view in the circumferential end portion of the cover 41. In the cover brim portion 45, a fitting groove 47, which is, when the tray 40 is overlapped with the cover 41 in the up-down direction, fitted into the upper end portion of the tray frame portion 44, is formed.

The cover flat plate portion 46 is formed into a generally U-shape in sectional view having an opening downwardly and formed into a flat plate shape disposed at the inner side of the cover brim portion 45. The cover flat plate portion 46 is formed so as to protrude toward the upper side with respect to the cover brim portion 45.

To house the encapsulating sheet 1 in the lid-including vessel 17, first, the tray 40 is prepared. Next, the release sheet 2 on which the encapsulating sheet 1 is laminated is disposed in the tray flat plate portion 43 in the tray 40. Thereafter, the cover 41 is overlapped with the tray 40 so that the upper end portion of the tray frame portion 44 is fitted into the fitting groove 47. In this manner, a housing space is divided between the tray flat plate portion 43 and the cover flat plate portion 46. The encapsulating sheet 1 is housed in the housing space in the lid-including vessel 17 at spaced intervals to the cover flat plate portion 46 in the cover 41.

The lid-including vessel 17 that houses the encapsulating sheet 1 can be further housed in a storage bag (pouch) or the like made of, for example, metals such as aluminum or resins such as polypropylene and polyethylene. In this manner, a rapid temperature change of the encapsulating sheet 1 can be prevented, to be specific, a rapid increase in temperature at the time of bringing the cooled encapsulating sheet 1 back to the room temperature to be described

later can be prevented. Preferably, in view of vapor blocking properties, a pouch made of aluminum is used.

The lid-including vessel 17 can prevent the encapsulating sheet 1 from being in contact with another member.

<Encapsulating Step>

As shown in FIG. 2, the encapsulating step is performed in the encapsulating area 11. The encapsulating area 11 includes an LED preparing area 11a, a providing/pressing area 11b, and a C-stage conversion area 11c.

To be specific, first, in the LED preparing area 11a in FIG. 2, the board 6 mounted with the LED 4 shown in FIG. 9 is prepared.

The board 6 is formed of, for example, an insulating board such as a laminate board in which an insulating layer is laminated on a silicone board, a ceramic board, a polyimide resin board, or a metal board.

In the surface of the board 6, a conductive pattern (not shown) including an electrode (not shown) to be electrically connected to a terminal (not shown) of the LED 4 to be described next and a wire to be continuous thereto is formed. The conductive pattern is formed of, for example, a conductor such as gold, copper, silver, and nickel.

The LED 4 is an optical semiconductor element that converts electrical energy to light energy. The LED 4 is, for example, formed into a generally rectangular shape in sectional view with its thickness shorter than a length in a plane direction (length in a direction orthogonal to the thickness direction).

An example of the LED 4 includes a blue LED (light emitting diode element) that emits blue light. The LED 4 has a thickness of, for example, 10 to 1000 μm.

The LED 4 is, for example, wire-bonding connected to or flip-chip mounted on the board 6. Preferably, as shown by the dashed lines in FIG. 9, the LED 4 is mounted on the board 6 and the terminal of the LED 4 is wire-bonding connected to an electrode of the board 6 using the wire 7.

When the terminal of the LED 4 is wire-bonding connected to the electrode of the board 6, a terminal, which is not shown, is formed in the surface of the LED 4. The terminal is electrically connected to the electrode (not shown) provided at spaced intervals in the right-left direction to a mounting position of the LED 4 in the surface of the board 6 via the wire 7.

The wire 7 is formed into linear. One end thereof is electrically connected to the terminal of the LED 4, while the other end thereof is electrically connected to the electrode (not shown) of the board 6.

An example of the material of the wire 7 includes a metal material that is used as a wire bonding material of the LED, such as gold, silver, and copper. In view of corrosion resistance, preferably, gold is used.

The wire 7 has a size (thickness) of, for example, 10 μm or more, preferably 20 μm or more, and for example, 100 μm or less, preferably 50 μm or less.

The wire 7 is formed into a generally arc shape (e.g., triangular arc shape, quadrangular arc shape, circular arc shape, etc.) by being curved or bent in a state of connecting the terminal of the LED 4 to the electrode of the board 6.

Next, in this method, in the providing/pressing area 11b shown in FIG. 2, the board 6 mounted with the LED 4 is provided in the pressing machine 20 shown in FIG. 9.

The pressing machine 20 is disposed continuously in (over) the providing/pressing area 11b and the C-stage conversion area 11c. An example of the pressing machine 20 includes a flat plate pressing machine including two pieces of flat plates 21 that are disposed in opposed relation at spaced intervals to each other in the up-down direction. The two pieces of flat plates 21 are configured to be movable in both areas of the providing/pressing area 11b and the C-stage conversion area 11c.

In the providing/pressing area 11b, to be specific, the board 6 mounted with the LED 4 is provided in the lower-side flat plate 21.

Subsequently, the encapsulating sheet 1 supplied from the conveying area 10 shown in FIG. 2 is reversed upside down to be disposed in opposed relation to the upper side of the LED 4. That is, the encapsulating sheet 1 is disposed so as to face the LED 4.

Next, as shown in FIG. 10, the LED 4 is embedded by the encapsulating sheet 1.

To be specific, as shown by the arrows in FIG. 9, the encapsulating sheet 1 is lowered (pushed down). To be more specific, the encapsulating sheet 1 is pressed toward the board 6 mounted with the LED 4. To be specific, the upper-side flat plate 21 is brought into closer contact with the lower-side flat plate 21.

The pressing pressure is, for example, 0.05 MPa or more, preferably 0.1 MPa or more, and for example, 1 MPa or less, preferably 0.5 MPa or less.

In this manner, the LED 4 and the wire 7 are covered with the encapsulating sheet 1. That is, the LED 4 and the wire 7 are embedded in the encapsulating sheet 1.

In this manner, the LED 4 and the wire 7 are encapsulated by the encapsulating sheet 1.

Thereafter, in the C-stage conversion area 11c in FIG. 2, the encapsulating sheet 1 is brought into a C-stage state.

In the C-stage conversion area 11c, an oven in provided.

When the two-step curable type resin is a two-step curable type thermosetting resin, the encapsulating sheet

1 is heated. To be specific, while a pressing state of the flat plates 21 with respect to the encapsulating sheet 1 is retained, the flat plates 21 are moved to the C-stage conversion area 11c to be then put into the oven. In this manner, the encapsulating sheet 1 is heated.

The heating temperature is, for example, 80°C or more, preferably 100°C or more, and for example, 200°C or less, preferably 180°C or less. The heating time is, for example, 10 minutes or more, preferably 30 minutes or more, and for example, 10 hours or less, preferably 5 hours or less.

The encapsulating sheet 1 is brought into a C-stage state (completely cured) by the heating of the encapsulating sheet 1.

When the two-step curable type resin is a two-step curable type active energy ray curable type resin, in the C-stage conversion area 11c, the encapsulating sheet 1 is brought into a C-stage state (completely cured) by applying an active energy ray to the encapsulating sheet 1. To be specific, ultraviolet rays are applied to the encapsulating sheet 1 using an ultraviolet ray lamp or the like.

In this producing method, time T from producing the encapsulating sheet 1 in the sheet producing step in the sheet producing area 9 (B-stage conversion area 9c) (to be specific, from the time of bringing the varnish into a B-stage state) to encapsulating the LED 4 by the encapsulating sheet 1 in the encapsulating step in the encapsulating area 11 (providing/pressing area 11b) (to be specific, to the time of embedding the LED 4 by the encapsulating sheet 1) is 24 hours or less, preferably 18 hours or less, more preferably 12 hours or less, further more preferably 6 hours or less, particularly preferably 3 hours or less, and for example, 1 second or more, preferably 1 minute or more.

When the above-described time T is above the above-described upper limit, improvement of the production efficiency of the LED device 5 is insufficient.

In this manner, as an optical semiconductor device, the LED device 5 including the encapsulating sheet 1, the LED 4 encapsulated by the encapsulating sheet 1, and the board 6 mounted with the LED 4 is produced.

Thereafter, as shown by the phantom lines in FIG. 10, if necessary, the release sheet 2 is peeled from the encapsulating sheet 1.

When the encapsulating sheet 1 encapsulates a plurality of LEDs 4, though not shown, thereafter, if necessary, the encapsulating sheet 1 is cut corresponding to each of the LEDs 4 to be singulated.

According to this method, the time T from producing the encapsulating sheet 1 in the sheet producing step to encapsulating the LED 4 by the encapsulating sheet 1 in the encapsulating step is short, so that the production efficiency of the LED device 5 can be improved.

To be more specific, in the conventional method, the encapsulating sheet 1 is produced in a sheet producing factory to be sent. Thereafter, the LED 4 is encapsulated by the encapsulating sheet 1 in an encapsulating factory (to be specific, LED device producing factory), which is located at a different place from the sheet producing factory.

However, in this method, in one (same) factory, to be specific, in the LED device producing factory 8, the sheet producing area 9, the conveying area 10, and the encapsulating area 11 are included and the above-described steps are performed in each area in the LED device producing factory 8. In other words, the sheet producing factory is provided in the LED device producing factory and in the same factory, the sheet producing step and the encapsulating step are performed. By such a method, the above-described time T can be short.

Furthermore, according to this method, the state before the C-stage state of the encapsulating sheet 1, to be specific, the B-stage state of the encapsulating sheet 1 is not required to be retained for a long period of time, so that the encapsulating sheet 1 in the B-stage state can be easily designed and managed. Thus, a degree of freedom in design and management of the encapsulating sheet 1 in the B-stage state can be increased.

In the conventional method, the conveyance and storage of the encapsulating sheet 1 requires a long period of time, so that the encapsulating sheet 1 in the B-stage state is required to be cooled (frozen) at a lower temperature to be conveyed and stored for prevention of the encapsulating sheet 1 from the state before the C-stage state, to be specific, the B-stage state into the C-stage state.

According to this method, however, the time T from the state before the C-stage state, to be specific, the B-stage state to the C-stage state is short, so that the encapsulating sheet 1 in the B-stage state produced in the sheet producing step can be conveyed at the room temperature to be supplied to the encapsulating step. Thus, the number of steps and equipment for the above-described cooling are unnecessary and as a result, the production cost of the LED device 5 can be reduced.

When the encapsulating sheet 1 is cooled, it is required that the cooled encapsulating sheet 1 is brought back to the room temperature and then, the LED 4 is encapsulated by the encapsulating sheet 1. When the cooled encapsulating sheet 1 is brought back to the room temperature for a short period of time, there may be a case where dew condensation occurs in the encapsulating sheet 1 and encapsulation of the LED 4 by the dew-condensed encapsulating sheet 1 causes a void, thereby reducing the reliability of the LED device 5.

Meanwhile, when the cooled encapsulating sheet 1 is brought back to the room temperature over a long period of time for prevention of dew condensation of the encapsulating sheet 1, the production efficiency of the LED device 5 is significantly reduced.

According to this method, however, the above-described cooling is unnecessary and thus, it is unnecessary to bring the cooled encapsulating sheet 1 back to the room temperature, so that the production time can be shortened. Thus, the production cost can be reduced. Furthermore, the occurrence of a void caused by the above-described dew condensation can be prevented, so that the LED device 5 having excellent reliability can be produced.

Furthermore, according to this method, in the encapsulating step, the LED 4 is encapsulated by the encapsulating sheet 1 in the B-stage state, so that the LED 4 can be easily encapsulated by the encapsulating sheet 1 in the B-stage state having more excellent handleability than an encapsulating layer 61 (described later) in an A-stage state, which is liquid.

When the encapsulating sheet 1 produced in the sheet producing step has a compressive elastic modulus at 25°C of 0.040 MPa or more and 0.145 MPa or less, a usable range of the compressive elastic modulus of the encapsulating sheet 1 is wide, so that a degree of freedom in design of the encapsulating sheet 1 can be further increased.

According to this method, the LED 4 can be encapsulated by the encapsulating sheet 1 having a large increase amount $\Delta M$ of the compressive elastic modulus at 25°C at the time of being preserved at 25°C for 24 hours. That is, by using a fast curable type encapsulating sheet 1, time required for C-stage conversion can be shortened. Thus, the production time of the LED device 5 can be shortened and as a result, the production cost can be reduced.

<Modified Example>

In the first embodiment, as shown by the solid arrows in FIG. 9, the upper-side flat plate 21 is brought into closer contact with the lower-side flat plate 21. Alternatively, for example, as shown by the dashed lines in FIG. 9, the lower-side flat plate 21 can be also brought into closer contact with the upper-side flat plate 21. That is, the board 6 that is disposed in the lower-side flat plate 21 and mounted with the LED 4 is pressed toward the encapsulating sheet 1.

In the above-described first embodiment in FIG. 9, the board 6 mounted with the LED 4 is disposed in the lower-side flat plate 21, and the release sheet 2 on which the encapsulating sheet 1 is laminated is disposed in the upper-side flat plate 21. Alternatively, for example, as referred to FIG. 15, the above-described arrangement can be reversed upside down. That is, the board 6 mounted with the LED 4 can be disposed in the upper-side flat plate 21, and the release sheet 2 on which the encapsulating sheet 1 is laminated can be disposed in the lower-side flat plate 21.

In the above-described first embodiment in FIG. 2, the C-stage conversion area 11c including the oven is provided in the encapsulating area 11. Alternatively, for example, though not shown, the encapsulating area 11 can be configured without providing the C-stage conversion area 11c in the encapsulating area 11. In such a case, for example, the flat plates 21 shown in FIG. 9 are equipped with a heater. The encapsulating sheet 1 in the B-stage state is heated by the heater, so that the encapsulating sheet 1 is brought into the C-stage state.

In the first embodiment in FIG. 2, the conveying area 10 is provided between the sheet producing area 9 and the encapsulating area 11. However, the arrangement is not limited to this. Or, the LED device producing factory 8 can be also configured without particularly providing the conveying area 10.

In the first embodiment in FIG. 10, as an optical semiconductor element and an optical semiconductor device of the present invention, the LED 4 and the LED device 5, respectively, are described as one example. Alternatively, for example, as an optical semiconductor element and an optical semiconductor device of the present invention, an LD (laser diode) 4 and a laser diode device 5, respectively, can be also used.

In the embodiment in FIG. 2, the sheet producing area 9 is provided in the LED device producing factory 8 in advance. Alternatively, for example, as shown in FIG. 12, an encapsulating sheet producing unit 91, which is movable, can be also provided in the LED device producing factory 8.

The encapsulating sheet producing unit 91 includes a container 92 and a sheet producing device 93 that is housed in the container 92.

The container 92 includes a casing 94, first wheels 95 as a running gear, a first connecting member 96, and a landing gear 97.

The sheet producing device 93 is housed in the casing 94. The sheet producing device 93 includes a varnish preparing device 98 and a sheet preparing device 99.

The varnish preparing device 98 includes, for example, the mixture vessel 52 and the stirrer 51.

The sheet preparing device 99 is disposed in adjacent to the varnish preparing device 98. The sheet preparing device 99 includes, for example, an application device 13 and a heating device 118.

An example of the application device 13 includes a dispenser.

An example of the heating device 118 includes a hot plate.

The members (the varnish preparing device 98 and the sheet preparing device 99) included in the above-described sheet producing device 93 are fixed to the casing 94.

(Production of Encapsulating Sheet 1)

Next, a method for producing the encapsulating sheet 1 using the encapsulating sheet producing unit 91 and thereafter, encapsulating the LED 4 by the encapsulating sheet 1 to produce the LED device 5 is described with reference to FIGS. 12 and 2.

<Moving of Encapsulating Sheet Producing Unit 91>

In this method, first, the encapsulating sheet producing unit 91 is moved to the LED device producing factory 8.
To be specific, the encapsulating sheet producing unit 91 is moved to an LED device producing building (not shown) in the LED device producing factory 8 or in the site thereof (hereinafter, these may be simply referred to as "in the LED device producing factory 8").
Or, the encapsulating sheet producing unit 91 is moved to a predetermined providing place (to be specific, providing place of the container 92 near the above-described LED device producing building (not shown)) or the like near the LED device producing factory 8.
First, as shown in FIG. 12, the encapsulating sheet producing unit 91 is connected to a trailer 150.
The trailer 150 includes a chassis 148, a cab 149, an engine 151 that is housed in the cab 149, second wheels 152 that are configured to be rotatable with respect to a wheel axis provided in the chassis 148, and a second connecting member 153.
To connect the encapsulating sheet producing unit 91 to the trailer 150, first, the rear-side portion of the chassis 148 is inserted into the lower-side portion of the container 92. Then, the second connecting member 153 is disposed in opposed relation to the first connecting member 96 in the up-down direction to be connected. Next, the container 92 is towed based on a driving force of the engine 151 of the trailer 150. At this time, the container 92 runs along with the trailer 150 by revolutions of the first wheels 95. Thereafter, the trailer 150 and the encapsulating sheet producing unit 91 are moved into the LED device producing factory 8 or a predetermined providing place. Next, as shown by the phantom lines and the arrow in FIG. 12, the landing gear 97 is protruded downwardly, so that the lower end portion of the landing gear 97 is grounded. Subsequently, the connection of the second connecting member 153 to the first connecting member 96 is released, and the rear-side portion of the cab 149 is separated from the lower-side portion of the container 92. In this manner, the trailer 150 is cut off from the container 92.

<Driving of Sheet Producing Device 93>

Next, in the container 92, the sheet producing device 93 is driven, thereby producing the encapsulating sheet 1. To be specific, a varnish is applied to a surface of a peeling sheet 2. Thereafter, when the varnish contains a two-step curable type thermosetting resin, by heating the varnish with the heating device 118, the varnish is brought into a B-stage state (semi-cured), thereby obtaining the encapsulating sheet 1.
Thereafter, the LED 4 is encapsulated by the obtained encapsulating sheet 1, thereby producing the LED device 5.
To be specific, the encapsulating sheet 1 in the B-stage state produced in the encapsulating sheet producing unit 91 is set in the pressing machine 20 (ref: FIG. 9) provided in a building (not shown) in the LED device producing factory.
As shown in FIG. 9, first, the board 6 mounted with the LED 4 is separately prepared and then, the board 6 is set in the above-described hot pressing device.
Next, in this method, as shown in FIG. 9, the encapsulating sheet 1 (ref: FIG. 12) laminated on the upper surface of the peeling sheet 2 is reversed upside down to be disposed in opposed relation to the upper side of the LED 4. That is, the encapsulating sheet 1 is disposed so as to face the LED 4. To be specific, the encapsulating sheet 1, the LED 4, and the board 6 are disposed in the pressing machine 20 provided in the building in the LED device producing factory.
In this manner, the LED device 5 including the encapsulating sheet 1, the LED 4 encapsulated by the encapsulating sheet 1, and the board 6 mounted with the LED 4 is produced.
Thereafter, if necessary, as shown in FIG. 10, the peeling sheet 2 is peeled from the encapsulating sheet 1.

(Termination of production of Necessary Number of Encapsulating Sheet 1)

When the necessary number of encapsulating sheet 1 is produced by the encapsulating sheet producing unit 91 and the necessary number of LED device 5 is produced in the pressing machine 20, next, the encapsulating sheet producing unit 91 is moved into another LED device producing factory or another providing place, to be specific, into a next LED device producing factory or a next providing place, which is provided in a separate region from the first LED device producing factory 8. Thereafter, the trailer 150 and the encapsulating sheet producing unit 91 are moved from the first LED device producing factory 8 or the first providing place to the next LED device producing factory or the next

providing place.

(Function and Effect)

According to the encapsulating sheet producing unit 91 of the modified example, the sheet producing device 93, along with the container 92, can be moved into the LED device producing factory encapsulating the LED 4, which is an object to be encapsulated, by the encapsulating sheet 1 in the B-stage state or a providing place of the container 92 near the LED device producing factory. Thus, the encapsulating sheet 1 in the B-stage state can be produced in the LED device producing factory 8 or the providing place. Thus, the produced encapsulating sheet 1 in the B-stage state, as it is, can be conveyed to the pressing machine 20 provided in the building (not shown) in the LED device producing factory 8 for a short period of time. As a result, the conveying time for conveying the encapsulating sheet 1 after production can be significantly shortened.
Also, the encapsulating sheet 1 is produced in the LED device producing factory 8 or the providing place and thereafter, in the LED device producing factory 8, the LED 4 can be encapsulated by the encapsulating sheet 1 in the B-stage state. Thus, the LED 4 can be surely encapsulated by the encapsulating sheet 1 in the B-stage state. Therefore, the above-described cooling unit is unnecessary, so that the production cost can be suppressed.

<Second Embodiment>

A method for producing the LED device 5 that is the second embodiment of the method for producing an optical semiconductor device of the present invention is described with reference to FIGS. 13 to 16.
In the second embodiment, the same reference numerals are provided for members and steps corresponding to each of those in the first embodiment, and their detailed description is omitted.
In the first embodiment, the encapsulating sheet 1 in the B-stage state as an encapsulating layer is produced and next, an optical semiconductor element 3 is encapsulated by the encapsulating sheet 1 in the B-stage state. Alternatively, the encapsulating layer 61 in an A-stage state as an encapsulating layer is produced and next, the optical semiconductor element 3 can be also encapsulated by the encapsulating layer 61 in the A-stage state.
As shown in FIGS. 15 and 16, in the method for producing the LED device 5 in the second embodiment, the LED 4 is encapsulated by the encapsulating layer 61 in the A-stage state to produce the LED device 5. As shown in FIG. 14, the method for producing the LED device 5 includes an encapsulating layer producing step of producing the encapsulating layer 61 in the A-stage state and an encapsulating step of encapsulating the LED 4 by the encapsulating layer 61 in the A-stage state. The method for producing the LED device 5 includes a conveying step of conveying the encapsulating layer 61 in the A-stage state produced in the encapsulating layer producing step to the encapsulating step. In the method for producing the LED 4, the encapsulating layer producing step, the conveying step, and the encapsulating step are sequentially performed.

<Encapsulating Layer Producing Step>

An encapsulating layer producing area 59 includes the varnish preparing area 9a and the application area 9b without including the B-stage conversion area 9c (ref: FIG. 2).
In the encapsulating layer producing step, to produce the encapsulating layer 61 in the A-stage state, first, for example, in the varnish preparing area 9a, an encapsulating resin composition is prepared.
The encapsulating resin composition contains a one-step curable type resin. The encapsulating resin composition preferably consists of the one-step curable type resin.
The one-step curable type resin is a curable type resin which has a one-step reaction mechanism and in which in a first-step reaction, the resin is completely cured. Examples of the one-step curable type resin include a one-step curable type thermosetting resin that cures by heating and a one-step curable type active energy ray curable type resin that cures by application of active energy rays (e.g., ultraviolet rays, electron rays, etc.). Preferably, a one-step curable type thermosetting resin is used.
To be specific, examples of the one-step curable type thermosetting resin include silicone resin, epoxy resin, polyimide resin, phenol resin, urea resin, melamine resin, and unsaturated polyester resin. Preferably, in view of light transmittance and durability, a one-step curable type silicone resin is used.
The one-step curable type resin in the A-stage state has a viscosity of, for example, 1,000 mPa·s or more, preferably 3,000 mPa·s or more, more preferably 5,000 mPa·s or more, and for example, 1,000,000 mPa·s or less, preferably 500,000 mPa·s or less, more preferably 200,000 mPa·s or less.
The encapsulating resin composition can also contain, if necessary, the above-described phosphor and/or the above-described filler at the above-described mixing proportion.
To be specific, as shown in FIGS. 3A and 14, to prepare the encapsulating resin composition, in the varnish

preparing area 9a, the above-described components are blended in the mixture vessel 52 having the stirrer 51 to be subsequently mixed using the stirrer 51.

To be more specific, the one-step curable type resin in the A-stage state, the phosphor and/or the filler, and if necessary, a solvent are blended and mixed. In this manner, the encapsulating resin composition in the A-stage state is prepared as a varnish.

The viscosity of the varnish under the conditions of 25°C and 1 atmospheric pressure is set such a degree that when the varnish is applied to the release sheet 2 (described later), the applied varnish does not fall from the circumferential end portion of the upper surface of the release sheet 2 (ref: FIG. 15). To be specific, the varnish has a viscosity of, for example, 1,000 mPa·s or more, preferably 4,000 mPa·s or more, more preferably 8,000 mPa·s or more, and for example, 1,000,000 mPa·s or less, preferably 500,000 mPa·s or less, more preferably 200,000 mPa·s or less.

Next, in this method, in the application area 9b shown in FIG. 14, the encapsulating resin composition (varnish) in the A-stage state is applied to the release sheet 2.

When the varnish contains a solvent, the encapsulating layer 61 after application can be also heated. To be specific, though not shown in FIG. 14, as referred to FIG. 3C, the encapsulating layer 61 is heated by the oven 55 including the two pieces of heaters 54. The heating conditions are the conditions in which a curing reaction of a curable resin is not substantially accelerated. To be specific, the heating temperature is, for example, 40°C or more, preferably 60°C or more, and for example, 150°C or less, preferably 130°C or less. The heating time is, for example, 1 minute or more, preferably 5 minutes or more, and for example, 60 minutes or less, preferably 40 minutes or less.

The applied encapsulating layer 61 in the A-stage state has a thickness of, for example, 10 μm or more, preferably 50 μm or more, and for example, 2,000 μm or less, preferably 1,000 μm or less.

In this manner, the encapsulating layer 61 in the A-stage state is produced.

<Conveying Step>

As shown in FIG. 14, the conveying step is performed in the conveying area 10. That is, in the conveying step, in the encapsulating layer producing area 59, the encapsulating layer 61 produced in the encapsulating layer producing step is conveyed at the room temperature to be supplied to the encapsulating area 11 in which the encapsulating step is performed in the same manner as that in the first embodiment. Or, the encapsulating layer 61 is conveyed at a lower temperature of less than the room temperature.

<Encapsulating Step>

As shown in FIG. 14, the encapsulating step is performed in the encapsulating area 11. The encapsulating area 11 includes the LED preparing area 11 a, a providing/embedding area 11d, and the C-stage conversion area 11c.

To be specific, first, in the LED preparing area 11 a in FIG. 14, as shown in FIG. 15, the board 6 mounted with the LED 4 is prepared.

Next, in this method, in the providing/embedding area 11d shown in FIG. 14, the board 6 mounted with the LED 4 is provided in a laminate device 55 shown in FIG. 15.

The laminate device 55 is disposed continuously in (over) the providing/embedding area 11d and the C-stage conversion area 11c. The laminate device 55 includes, for example, the two pieces of flat plates 21 that are disposed in opposed relation at spaced intervals to each other in the up-down direction. The two pieces of flat plates 21 are configured to be movable in both areas of the providing/embedding area 11d and the C-stage conversion area 11c.

In the providing/embedding area 11d, to be specific, the board 6 mounted with the LED 4 is provided in the upper-side flat plate 21. To be specific, the board 6 is provided on the lower surface of the flat plate 21 so that the LED 4 faces downwardly.

Subsequently, the encapsulating layer 61 supplied from the conveying area 10 shown in FIG. 14 is provided in the lower-side flat plate 21. That is, the encapsulating layer 61 is disposed so as to face the LED 4.

Next, as shown in FIG. 16, the LED 4 is embedded by the encapsulating layer 61.

To be specific, as shown by the arrows in FIG. 15, the upper-side flat plate 21 is lowered (pushed down) so that the board 6 mounted with the LED 4 is lowered. Or, as shown by dashed arrows in FIG. 15, the lower-side flat plate 21 is lifted (pushed up) so that the encapsulating layer 61 laminated on the release sheet 2 is lifted.

In this manner, the LED 4 and the wire 7 are covered with the encapsulating layer 61. That is, the LED 4 and the wire 7 are embedded in the encapsulating layer 61.

In this manner, the LED 4 and the wire 7 are encapsulated by the encapsulating layer 61.

Thereafter, in the C-stage conversion area 11c in FIG. 14, the encapsulating layer 61 is brought into a C-stage state.

In the C-stage conversion area 11c, an oven in provided.

When the one-step curable type resin is a one-step curable type thermosetting resin, the encapsulating layer

61 is heated. To be specific, while a holding state of the flat plates 21 with respect to the encapsulating layer 61 is retained, the flat plates 21 are moved to the C-stage conversion area 11c to be then put into the oven. In this manner, the encapsulating layer 61 is heated.

The heating temperature is, for example, 80°C or more, preferably 100°C or more, and for example, 200°C or less, preferably 180°C or less. The heating time is, for example, 10 minutes or more, preferably 30 minutes or more, and for example, 10 hours or less, preferably 5 hours or less.

The encapsulating layer 61 in the A-stage state is brought into a C-stage state (completely cured) by the heating of the encapsulating layer 61.

When the one-step curable type resin is a one-step curable type active energy ray curable type resin, in the C-stage conversion area 11c, the encapsulating layer 61 in the A-stage state is brought into a C-stage state (completely cured) by applying an active energy ray to the encapsulating layer 61. To be specific, ultraviolet rays are applied to the encapsulating layer 61 in the A-stage state using an ultraviolet ray lamp or the like.

In this producing method, the time T from producing the encapsulating sheet 1 in the encapsulating layer producing step in the encapsulating layer producing area 59 (application area 9b) (to be specific, from the time of applying the varnish to the release sheet 2) to encapsulating the LED 4 by the encapsulating sheet 1 in the encapsulating step in the encapsulating area 11 (providing/embedding area 11d) (to be specific, to the time of embedding the LED 4 by the encapsulating sheet 1) is 24 hours or less, preferably 18 hours or less, more preferably 12 hours or less, further more preferably 6 hours or less, particularly preferably 3 hours or less, and for example, 1 second or more, preferably 1 minute or more.

When the above-described time T is above the above-described upper limit, improvement of the production efficiency of the LED device 5 is insufficient.

In this manner, as an optical semiconductor device, the LED device 5 including the encapsulating sheet 1, the LED 4 encapsulated by the encapsulating sheet 1, and the board 6 mounted with the LED 4 is produced.

Thereafter, as shown by the phantom lines in FIG. 16, if necessary, the release sheet 2 is peeled from the encapsulating sheet 1.

According to this method, the time T from producing the encapsulating layer 61 in the A-stage state in the encapsulating layer producing step to encapsulating the LED 4 by the encapsulating layer 61 in the A-stage state in the encapsulating step is short, so that the production efficiency of the LED device 5 can be improved.

To be more specific, in this method, in one (same) factory, to be specific, in the LED device producing factory 8, the encapsulating layer producing area 59, the conveying area 10, and the encapsulating area 11 are included and the above-described steps can be performed in each area in the LED device producing factory 8. In other words, the encapsulating layer producing factory is provided in the LED device producing factory and in the same factory, the encapsulating layer producing step and the encapsulating step are performed. By such a method, the above-described time T can be short.

Furthermore, according to this method, the A-stage state of the encapsulating layer 61 is not required to be retained for a long period of time, so that the encapsulating layer 61 in the A-stage state can be easily designed and managed. Thus, a degree of freedom in design and management of the encapsulating layer 61 in the A-stage state can be increased.

According to this method, the time T from the A-stage state to the C-stage state is short, so that the encapsulating layer 61 produced in the encapsulating layer producing step can be conveyed at the room temperature to be supplied to the encapsulating step. Thus, the number of steps and equipment for the above-described cooling are unnecessary and as a result, the production cost of the LED device 5 can be reduced.

Furthermore, according to this method, the above-described cooling is unnecessary and thus, it is unnecessary to bring the cooled encapsulating layer 61 in the A-stage state back to the room temperature, so that the production time can be shortened. Thus, the production cost can be reduced. Furthermore, the occurrence of a void caused by the above-described dew condensation can be prevented, so that the LED device 5 having excellent reliability can be produced.

<Modified Example>

In the embodiment in FIG. 14, the encapsulating layer producing area 59 is provided in the LED device producing factory 8 in advance. Alternatively, for example, as referred to FIG. 12, an encapsulating layer producing unit 191, which is movable, can be also provided in the LED device producing factory 8.

The encapsulating layer producing unit 191 is configured in the same manner as that in the encapsulating sheet producing unit 91, except that the heating device 118 is not provided (the embodiment is not shown in FIG. 12). The encapsulating layer producing unit 191, an encapsulating layer producing device 193, and an encapsulating layer preparing device 199 serve as the encapsulating sheet producing unit 91, the sheet producing device 93, and the sheet preparing device 99, respectively.

By the encapsulating layer producing unit 191, the encapsulating layer 61 in the A-stage state can be also produced. Thereafter, the LED device 5 can be produced by the encapsulating layer 61.

Examples

The values shown in Examples, Production Examples, Reference Examples, and Comparative Examples below can be replaced with the corresponding values shown in the above-described embodiments (that is, upper limit value or lower limit value).

<Encapsulating Sheet Producing Step>

Production Example 1

In the sheet producing area (ref: FIG. 2), an encapsulating sheet was produced. To be specific, first, with respect to 2031 g (0.177 mol) of polydimethylsiloxane containing silanol groups at both ends that was heated at 40°C [compound in which all of $R^1$s were a methyl group and n = 155 in formula (1) below, average molecular weight of 11,500], as an ethylenically unsaturated hydrocarbon group-containing silicon compound, 15.76 g (0.106 mol) of vinyltrimethoxysilane [compound in which $R^2$ was a vinyl group and all of $X^1$s were a methoxy group in formula (2) below] and as an ethylenically unsaturated hydrocarbon group-containing silicon compound, 2.80 g (0.0118 mol) of (3-glycidoxypropyl)trimethoxysilane [compound in which $R^3$ was a 3-glycidoxypropyl group and all of $X^2$s were a methoxy group in formula (3) below][ratio [$SiOH/(SiX^1 + SiX^2) = 1/1$] of number of moles of SiOH group in the polydimethylsiloxane containing silanol groups at both ends to the total number of moles of $SiX^1$ group in the ethylenically unsaturated hydrocarbon group-containing silicon compound and $SiX^2$ group in the ethylenically unsaturated hydrocarbon group-containing silicon compound] were stirred and mixed. Thereafter, as a condensation catalyst, 0.97 mL (catalyst amount: 0.88 mol, 0.50 mol with respect to 100 mol of the polydimethylsiloxane containing silanol groups at both ends, 4.0 mg with respect to 100 g of the condensation catalyst) of methanol solution of tetramethylammonium hydroxide (concentration of 10 mass%) was added thereto to be then stirred at 40°C for 1 hour. While stirred at 40°C for 1 hour, the pressure of the obtained oil was reduced (10 mmHg), so that a volatile component was removed. Next, after the reaction liquid was brought back to a normal pressure, organohydrogenpolysiloxane (dimethylpolysiloxane-co-methylhydrogenpolysiloxane) was added thereto so that the molar ratio of the alkenyl group with respect to the hydrosilyl group was $SiR^2/SiH = 1/3.0$ to be then stirred at 40°C for 1 hour. Thereafter, as a hydrosilylation catalyst, 0.038 mL (platinum content was 0.375 ppm with respect to the organopolysiloxane, that is, $0.375 \times 10^{-4}$ g with respect to 100 g of addition material) of platinum-carbonyl complex (platinum concentration of 2.0 mass%) was added thereto to be stirred at 40°C for 10 minutes, thereby preparing a silicone resin composition (second condensation reaction and addition reaction curable type silicone resin).

[Chemical Formula 1]

【Chemical Formula 1】

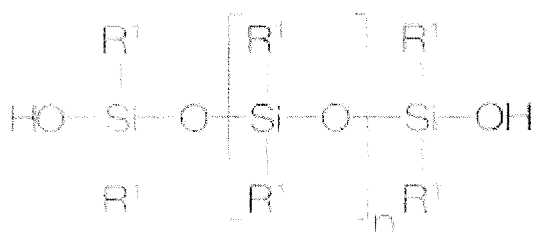

(1)

[Chemical Formula 2]

【Chemical Formula 2】

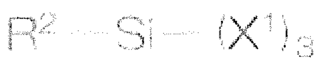

(2)

[Chemical Formula 3]

【Chemical Formula 3】

$$R^3-Si-(X^2)_3 \qquad (3)$$

A mixture vessel equipped with a stirrer was charged with 100 parts by mass of silicone resin composition, 20 parts by mass of silicone rubber particles (average particle size of 7 μm), and 10 parts by mass of YAG particles (average particle size of 7 μm), which were a yellow phosphor, and then, the charged components were mixed using the stirrer. In this manner, a varnish was prepared in the varnish preparing area (ref: FIG. 2). The varnish had a viscosity under the conditions of 25°C and 1 pressure of 20,000 mPa·s.
Next, in the application area (ref: FIG. 2), the varnish in a rectangular shape in plane view (size: 10 mm × 100 mm) was applied to a surface of a release sheet made of PET with a dispenser (ref: FIG. 3B). Subsequently, in the B-stage conversion area, the applied varnish was heated in an oven at 135°C for 15 minutes, thereby producing an encapsulating sheet in a B-stage state laminated on the release sheet and having a thickness of 600 μm.
According to the measurement, it was found that the encapsulating sheet in the B-stage state immediately after production had the compressive elastic modulus M0 at 25°C of 0.040 MPa (ref: Table 1). To be specific, the compressive elastic modulus at 25°C was calculated with a precision load measuring device manufactured by AIKOH ENGINEERING CO., LTD. The compressive elastic modulus to be described later was calculated in the same manner as that in the above-described method.

Production Examples 2 to 10

As Production Examples 2 to 10, each of the encapsulating sheets having a compressive elastic modulus described in Table 1 was obtained by appropriately adjusting the heating time of the oven in the application area to be 15 minutes or more and 25 minutes or less in Production Example 1.

<Conveying Step and Encapsulating Step>

<Encapsulation by Encapsulating Sheet Conveyed at 25°C/Time T: 1 Minute>

Examples 1 to 10

Each of the boards in which an LED in a rectangular shape in plane view was wire-bonding connected in the LED preparing area in the encapsulating area (ref: FIG. 2) was prepared (ref: FIG. 9). The size of the LED and the wire was as follows.
LED thickness: 150 μm
Wire size: 30 μm
Subsequently, the board in which the LED was wire-bonding connected was provided in a pressing machine in the encapsulating area (ref: FIGS. 2 and 9).
Separately, in the conveying area, each of the encapsulating sheets in the B-stage state immediately after production in Production Examples 1 to 10 was housed in a lid-including vessel at room temperature (25°C). Immediately, in the encapsulating area, the encapsulating sheet was taken out from the lid-including vessel to be disposed in the pressing machine having the board provided therein in the providing/pressing area.
Subsequently, the LED and the wire were encapsulated by the encapsulating sheet.
To be specific, the encapsulating sheet was pushed down at the room temperature by flat plate pressing and then, the LED and the wire were embedded by the encapsulating sheet at a pressure of 0.3 MPa. In this manner, the LED and the wire were encapsulated by the encapsulating sheet.
The compressive elastic modulus M1 at 25°C of the encapsulating sheet in the B-stage state at the time of embedding the LED and the wire is shown in Table 1.
The time T from producing the encapsulating sheet in the B-stage state (bringing it into the B-stage state) to encapsulating (embedding) the LED and the wire was 1 minute.
Thereafter, in the hot pressing area, the encapsulating sheet and the flat plate pressing the board were put into an oven. The encapsulating sheet was heated at 150°C for 2 hours, so that the encapsulating sheet was brought into a C-stage state.
Thereafter, a release sheet was peeled from the encapsulating sheet.
In this manner, an LED device was produced.
The encapsulating sheet in the LED device had a cure degree of 90% and a compressive elastic modulus of

0.040 MPa.

<Encapsulation by Encapsulating Sheet Preserved at 25°C/Time T: 24 Hours>

Examples 11 to 17

The process was performed in the same manner as that in Examples 1 to 5 and 7 and 8, except that the time T from producing the encapsulating sheet in the B-stage state (bringing it into the B-stage state) to encapsulating (embedding) the LED and the wire was changed from 1 minute to 24 hours.

The compressive elastic modulus M2 at 25°C of each of the encapsulating sheets in the B-stage state at the time of encapsulating (embedding) the LED and the wire in Examples 11 to 17 is shown in Table 1.

<Encapsulation by Encapsulating Sheet Preserved at 25°C/Time T: 36 Hours>

Comparative Examples 1 to 7

The process was performed in the same manner as that in Examples 1 to 5 and 7 and 8, except that the time T from producing the encapsulating sheet in the B-stage state (bringing it into the B-stage state) to encapsulating (embedding) the LED and the wire was changed from 1 minute to 36 hours.

The compressive elastic modulus M3 at 25°C of each of the encapsulating sheets in the B-stage state at the time of encapsulating (embedding) the LED and the wire in Comparative Examples 1 to 7 is shown in Table 1.

<Encapsulation by Encapsulating Sheet Preserved at 40°C/Time T: 24 Hours>

Examples 18 to 23

The process was performed in the same manner as that in Examples 1 to 6, except that the time T from producing the encapsulating sheet in the B-stage state (bringing it into the B-stage state) to encapsulating (embedding) the LED and the wire was changed from 1 minute to 24 hours and the temperature in the conveying area was changed from the room temperature (25°C) to 40°C.

The compressive elastic modulus M4 at 25°C of each of the encapsulating sheets in the B-stage state at the time of encapsulating (embedding) the LED and the wire in Examples 18 to 23 is shown in Table 1.

<Encapsulation by Encapsulating Sheet Preserved at 40°C/Time T: 36 Hours>

Comparative Examples 8 to 13

The process was performed in the same manner as that in Examples 1 to 6, except that the time T from producing the encapsulating sheet in the B-stage state (bringing it into the B-stage state) to encapsulating (embedding) the LED and the wire was changed from 1 minute to 36 hours and the temperature in the conveying area was changed from the room temperature (25°C) to 40°C.

The compressive elastic modulus M5 at 25°C of each of the encapsulating sheets in the B-stage state at the time of encapsulating (embedding) the LED and the wire in Comparative Examples 8 to 13 is shown in Table 1.

<Encapsulation by Encapsulating Sheet Preserved at -15°C/Time T: 24 Hours>

Examples 24 to 30

The process was performed in the same manner as that in Examples 1 to 5 and 7 and 9, except that the time T from producing the encapsulating sheet in the B-stage state (bringing it into the B-stage state) to encapsulating (embedding) the LED and the wire was changed from 1 minute to 24 hours and the temperature in the conveying area was changed from the room temperature (25°C) to -15°C.

The compressive elastic modulus M6 at 25°C of each of the encapsulating sheets in the B-stage state at the time of encapsulating (embedding) the LED and the wire in Examples 24 to 30 is shown in Table 1.

<Encapsulation by Encapsulating Sheet Preserved at -15°C/Time T: 36 Hours>

Comparative Examples 14 to 20

The process was performed in the same manner as that in Examples 1 to 5 and 7 and 9, except that the time T from producing the encapsulating sheet in the B-stage state (bringing it into the B-stage state) to encapsulating (embedding) the LED and the wire was changed from 1 minute to 36 hours and the temperature in the conveying area was changed from the room temperature (25°C) to -15°C.

The compressive elastic modulus M7 at 25°C of each of the encapsulating sheets in the B-stage state at the time of encapsulating (embedding) the LED and the wire in Comparative Examples 14 to 20 is shown in Table 1.

<Evaluation>

[Presence or Absence of Deformation of Wire]

When each of the wires in Examples 1 to 30 and Comparative Examples 1 to 20 was observed, deformation of the wire was confirmed in Comparative Examples 6, 7, 12, 13, and 20.

Meanwhile, deformation of the wire was not confirmed in Examples 1 to 30 and Comparative Examples 1 to 5, 8 to 11, and 14 to 19.

Properties and evaluation results of Production Examples, Examples, and Comparative Examples are shown in Table 1.

[Table 1]

Table 1

| Immediately after Production of Encapsulating Sheet in B-Stage State | Production Examples | Production Ex. 1 | Production Ex. 2 | Production Ex. 3 | Production Ex. 4 | Production Ex. 5 | Production Ex. 6 | Production Ex. 7 | Production Ex. 8 | Production Ex. 9 | Production Ex. 10 |
|---|---|---|---|---|---|---|---|---|---|---|---|
| | Compressive Elastic Modulus M0* (MPa) | 0.040 | 0.060 | 0.080 | 0.100 | 0.120 | 0.124 | 0.140 | 0.145 | 0.158 | 0.160 |
| After Preservation at 25°C for 1 Minute | Examples | Ex. 1 | Ex. 2 | Ex. 3 | Ex. 4 | Ex. 5 | Ex. 6 | Ex. 7 | Ex. 8 | Ex. 9 | Ex. 10 |
| | ΔM (= M1-M0) | 0.000 | 0.000 | 0.000 | 0.000 | 0.000 | 0.000 | 0.000 | 0.000 | 0.000 | 0.000 |
| | Comoressive Elastic Modulus M1∗(MPa) | 0.040 | 0.060 | 0.080 | 0.100 | 0.120 | 0.124 | 0.140 | 0.145 | 0.158 | 0.160 |
| | Deformation of Wire | Absence | Absence | Absence | Absence | Absence | Absence | Absence | Absence | Absence | Absence |
| After Preservation at 25°C for 24 Hours | Examples | Ex. 11 | Ex. 12 | Ex. 13 | Ex. 14 | Ex. 15 | - | Ex. 16 | Ex. 17 | - | - |
| | Compressive Elastic Modulus M2* (MPa) | 0.055 | 0.075 | 0.095 | 0.115 | 0.135 | | 0.155 | 0.160 | | |
| | ΔM(=M2-M0) | 0.015 | 0.015 | 0.015 | 0.015 | 0.015 | | 0.015 | 0.015 | | |
| | Deformation of Wire | Absence | Absence | Absence | Absence | Absence | | Absence | Absence | | |
| After Preservation at 25°C for 36 Hours | Comparative Examples | Comp. Ex.1 | Comp. Ex. 2 | Comp. Ex. 3 | Comp. Ex. 4 | Comp. Ex. 5 | - | Comp. Ex. 6 | Comp. Ex. 7 | - | - |
| | Compressive Elastic Modulus M3* (MPa) | 0.063 | 0.083 | 0.103 | 0.123 | 0.143 | | 0.163 | 0.168 | | |
| | ΔM(=M3-M0) | 0.023 | 0.023 | 0.023 | 0.023 | 0.023 | | 0.023 | 0.023 | | |
| | Deformation of Wire | Absence | Absence | Absence | Absence | Absence | | Presence | Presence | | |

(continued)

| Immediately after Production of Encapsulating Sheet in B-Stage State | Production Examples | Production Ex. 1 | Production Ex. 2 | Production Ex. 3 | Production Ex. 4 | Production Ex. 5 | Production Ex. 6 | Production Ex. 7 | Production Ex. 8 | Production Ex. 9 | Production Ex. 10 |
|---|---|---|---|---|---|---|---|---|---|---|---|
| | Compressive Elastic Modulus M0* (MPa) | 0.040 | 0.060 | 0.080 | 0.100 | 0.120 | 0.124 | 0.140 | 0.145 | 0.158 | 0.160 |
| After Preservation at 40°C for 24 Hours | Examples | Ex.18 | Ex. 19 | Ex. 20 | Ex. 21 | Ex. 22 | Ex. 23 | - | - | - | - |
| | Compressive Elastic Modulus M4* (MPa) | 0.076 | 0.096 | 0.116 | 0.136 | 0.156 | 0.160 | | | | |
| | ΔM (= M4-M0) | 0.036 | 0.036 | 0.036 | 0.036 | 0.036 | 0.036 | | | | |
| | Deformation of Wire | Absence | Absence | Absence | Absence | Absence | Absence | | | | |
| After Preservation at 40°C for 36 Hours | Comoarative Examples | Comp. Ex. 8 | Comp. Ex. 9 | Comp. Ex. 10 | Comp. Ex. 11 | Comp. Ex. 12 | Comp. Ex. 13 | - | - | - | - |
| | Compressive Elastic Modulus M5* (MPa) | 0.094 | 0.114 | 0.134 | 0.154 | 0.174 | 0.178 | | | | |
| | ΔM(=M5-M0) | 0.054 | 0.054 | 0.054 | 0.054 | 0.054 | 0.054 | | | | |
| | Deformation of Wire | Absence | Absence | Absence | Absence | Presence | Presence | | | | |
| After Preservation at -15°C for 24 Hours | Examples | Ex. 24 | Ex. 25 | Ex. 26 | Ex. 27 | Ex. 28 | - | Ex. 29 | - | Ex. 30 | - |
| | Compressive Elastic Modulus M6* (MPa) | 0.042 | 0.062 | 0.082 | 0.102 | 0.122 | | 0.142 | | 0.160 | |
| | ΔM (= M6-M0) | 0.002 | 0.002 | 0.002 | 0.002 | 0.002 | | 0.002 | | 0.002 | |
| | Deformation of Wire | Absence | Absence | Absence | Absence | Absence | | Absence | | Absence | |

(continued)

| Immediately after Production of Encapsulating Sheet in B-Stage State | Production Examples | Production Ex. 1 | Production Ex. 2 | Production Ex. 3 | Production Ex. 4 | Production Ex. 5 | Production Ex. 6 | Production Ex. 7 | Production Ex. 8 | Production Ex. 9 | Production Ex. 10 |
|---|---|---|---|---|---|---|---|---|---|---|---|
| | Compressive Elastic Modulus M0* (MPa) | 0.040 | 0.060 | 0.080 | 0.100 | 0.120 | 0.124 | 0.140 | 0.145 | 0.158 | 0.160 |
| After Preservation at -15°C for 36 Hours | Comparative Examples | Comp. Ex. 14 | Comp. Ex. 15 | Comp. Ex. 16 | Comp. Ex. 17 | Comp. Ex. 18 | | Comp. Ex. 19 | | Comp. Ex. 20 | |
| | Compressive Elastic Modulus M7* (MPa) | 0.043 | 0.063 | 0.083 | 0.103 | 0.123 | - | 0.143 | - | 0.161 | - |
| | ΔM(=M7-M0) | 0.003 | 0.003 | 0.003 | 0.003 | 0.003 | | 0.003 | | 0.003 | |
| | Deformation of Wire | Absence | Absence | Absence | Absence | Absence | | Absence | | Presence | |

*M1=Compressive Elastic Modulus at 25°C of Encapsulating Sheet in B-Stage State Immediately after Production M2 to M7=Compressive Elastic Modulus at 25°C of Encapsulating Sheet in B-Stage State at the Time of Embedding LED

<Description of Table>

The vertical columns in Table 1 show Examples and/or Comparative Examples in which the encapsulating sheets produced in Production Examples are preserved and used, and describe the compressive elastic modulus after preservation under the conditions described in left-end columns.

<Consideration 1>

(1) Compressive Elastic Modulus of Encapsulating Sheet and Deformation of Wire

(1-1) Upper Limit Value of Compressive Elastic Modulus

The evaluation results of Examples 1 to 30 and Comparative Examples 1 to 20 found that when the compressive elastic modulus (M1 to M7) of the encapsulating sheet in the B-stage state at the time of encapsulating (embedding) the LED was above 0.160 MPa (Comparative Examples 6, 7, 12, 13, and 20), deformation of the wire occurred; and when it was 0.160 MPa or less (Examples 1 to 30 and Comparative Examples 1 to 5, 8 to 11, and 14 to 19), deformation of the wire did not occur.

Accordingly, it was found that the upper limit of the compressive elastic modulus (M1 to M7) of the encapsulating sheet in the B-stage state at the time of encapsulating (embedding) the LED capable of encapsulating the LED without causing deformation of the wire was 0.160 MPa.

(1-2) Lower Limit Value of Compressive Elastic Modulus

It was found that the compressive elastic modulus M0 at 25°C of the encapsulating sheet in the B-stage state immediately after production of Production Example 1 was 0.040 MPa, and the shape of the encapsulating sheet could not be ensured with a lower compressive elastic modulus than the compressive elastic modulus M0. Therefore, it was found that the lower limit value of the compressive elastic modulus (M2) at 25°C of the encapsulating sheet at the time of encapsulating (embedding) the LED after Example 1, to be specific, the encapsulating sheet in the B-stage state immediately after production of Production Example 1 was preserved at normal temperature for 1 minute was 0.040 MPa.

(2) Compressive Elastic Modulus of Encapsulating Sheet Immediately after Production

In Examples 11 to 17, the compressive elastic modulus (M2) of the encapsulating sheet in the B-stage state at the time of encapsulating (embedding) the LED was in the range of 0.055 to 0.160 MPa, and encapsulation of the LED by using the encapsulating sheet did not cause deformation of the wire.

In each of Examples 11 to 17, after each of Production Examples 1 to 8 having the compressive elastic modulus (M0) of the encapsulating sheet in the B-stage state immediately after production in the range of 0.040 to 0.145 MPa was preserved at 25°C for 24 hours, the LED was encapsulated by the encapsulating sheet in the B-stage state.

Accordingly, it was found that when the compressive elastic modulus (M0) of the encapsulating sheet in the B-stage state immediately after production was set in the range of 0.040 to 0.145 MPa, the encapsulating sheet was preserved at normal temperature for 24 hours after production and thereafter, by using it for encapsulation of the LED 4, deformation of the wire could be prevented.

(3) (Fast Curable Type Encapsulating Sheet)

The compressive elastic modulus (M2) of the encapsulating sheet in the B-stage state at the time of encapsulating (embedding) in Example 11 with respect to the compressive elastic modulus (M0) of the encapsulating sheet in the B-stage state immediately after production in Production Example 1 was hither by 0.015 MPa ($\Delta$M = M2-M0). That is, in the produced encapsulating sheet, the compressive elastic modulus increases by 0.015 MPa ($\Delta$M) by preservation at 25°C for 24 hours.

Meanwhile, the compressive elastic modulus (M2) of 0.160 MPa of the encapsulating sheet in the B-stage state at the time of encapsulating (embedding) in Example 17 with respect to the compressive elastic modulus (M0) of 0.040 MPa of the encapsulating sheet in the B-stage state immediately after production in Production Example 1 was higher by 0.120 MPa. Then, considering that the upper limit of the compressive elastic modulus (M2) of the encapsulating sheet in the B-stage state at the time of encapsulating (embedding) the LED capable of encapsulating the LED without causing deformation of the wire was 0.160 MPa, a fast curable type encapsulating sheet having the compressive elastic modulus (M0) immediately after production of 0.040 MPa (Production Example 1) and the compressive elastic modulus (M2) at the time of encapsulating (embedding) of 0.160 MPa (Example 17) could be selected. In other words, it was found that

the upper limit of the increase amount ΔM of the compressive elastic modulus at 25°C at the time of preserving the fast curable type encapsulating sheet produced in the sheet producing step at 25°C for 24 hours capable of encapsulating the LED without causing deformation of the wire was 0.120 MPa.

(4) (Production Efficiency of LED Device at the Time of Using Fast Curable Type Encapsulating Sheet)

When a fast curable type encapsulating sheet having the increase amount ΔM of the compressive elastic modulus at 25°C of 0.120 MPa was used, the time for C-stage conversion under the heating conditions of 150°C was calculated as 15 minutes by the following formula.

$$2\ [\text{hours}] \times 0.015\ [\text{MPa}/2\ \text{hours}]/0.120\ [\text{MPa}/2\ \text{hours}] = 0.25\ [\text{hours}]\ (= 15\ \text{minutes})$$

Thus, a fast curable type encapsulating sheet could shorten the time for C-stage conversion by 8 times (= 2 [hours]/0.25 [hours]). That is, it was found that shortening of the time for C-stage conversion could significantly improve the production efficiency of the LED device.

[Bringing Cooled Encapsulating Sheet Back to Room Temperature]

Reference Example 1

The encapsulating sheet immediately after production of Production Example 1 was housed in the lid-including vessel 17 shown in FIG. 6. The lid-including vessels 17 were stacked by 5 stages in the up-down direction and these lid-including vessels 17 were housed in a pouch (storage bag) made of aluminum. Thereafter, the pouch was preserved in a freezer at -15°C for 3.5 hours. Thereafter, the pouch was taken out from the freezer to be then disposed on a stainless steel stand under an atmosphere of 20°C and relative humidity of 37% for a predetermined time. That is, the encapsulating sheets were brought back to the room temperature. Also, a surface temperature of the encapsulating sheets in the pouch at this time was measured.

The relationship between the surface temperature of the encapsulating sheet and an elapsed time after disposing the lid-including vessel on the stainless steel stand is shown in FIG. 11.

[Results]

As clear from FIG. 11, the time required for bringing the surface temperature of the encapsulating sheet in the cooled pouch back to the room temperature was 3 hours.

On the surface of the encapsulating sheet having the surface temperature brought back to the room temperature, dew condensation was not observed.

Reference Example 2

The process was performed in the same manner as that in Reference Example 1, except that the lid-including vessels 17 were taken out from the pouch taken out from the freezer, and the housing vessel was disposed as it was on a stainless steel stand under an atmosphere of 20°C and relative humidity of 37% for 3 hours.

[Results]

On the surface of the encapsulating sheet having the surface temperature brought back to the room temperature, dew condensation was observed.

<Consideration 2>

(Time for Bringing Cooled State to Room Temperature)

It was found that when the surface temperature of the encapsulating sheet cooled in the freezer was brought back to the room temperature (that is, the temperature for supplying the encapsulating sheet to the encapsulating step) without causing dew condensation, the encapsulating sheet was required to be preserved at the room temperature "in a state of being housed in the pouch".

Furthermore, it was found that the time required for bringing the surface temperature of the encapsulating sheet housed in the pouch back to the room temperature was "3 hours". That is, it was found that the production efficiency of the LED device was significantly reduced.

While the illustrative embodiments of the present invention are provided in the above description, such is for illustrative purpose only and it is not to be construed as limiting the scope of the present invention. Modification and variation of the present invention that will be obvious to those skilled in the art is to be covered by the following claims.

Industrial Applicability

The method for producing an optical semiconductor device is used as a method for producing an LED device or an LD device.

Description of Reference Numerals

1 Encapsulating sheet
4 LED
5 LED device
61 Encapsulating Layer

## Claims

**1.** A method for producing an optical semiconductor device producing an optical semiconductor device by encapsulating an optical semiconductor element by an encapsulating layer comprises:

an encapsulating layer producing step of producing the encapsulating layer and
an encapsulating step of encapsulating the optical semiconductor element by the encapsulating layer, wherein time from producing the encapsulating layer in the encapsulating layer producing step to encapsulating the optical semiconductor element by the encapsulating layer in the encapsulating step is 24 hours or less.

**2.** In the method for producing an optical semiconductor device according to claim 1, wherein
the encapsulating layer produced in the encapsulating layer producing step is conveyed at room temperature to be supplied to the encapsulating step.

**3.** In the method for producing an optical semiconductor device according to claim 1 producing the optical semiconductor device by encapsulating the optical semiconductor element by an encapsulating sheet in a B-stage state, wherein the encapsulating layer producing step is a sheet producing step of producing the encapsulating sheet in the B-stage state;
in the encapsulating step, the optical semiconductor element is encapsulated by the encapsulating sheet in the B-stage state; and
time from producing the encapsulating sheet in the B-stage state in the sheet producing step to encapsulating the optical semiconductor element by the encapsulating sheet in the B-stage state in the encapsulating step is 24 hours or less.

**4.** In the method for producing an optical semiconductor device according to claim 3, wherein
the encapsulating sheet in the B-stage state produced in the sheet producing step has a compressive elastic modulus at 25°C of 0.040 MPa or more and 0.145 MPa or less.

**5.** In the method for producing an optical semiconductor device according to claim 3, wherein
an increase amount of the compressive elastic modulus at 25°C at the time of preserving the encapsulating sheet in the B-stage state produced in the sheet producing step at 25°C for 24 hours is 0.015 MPa or more and 0.120 MPa or less.

**6.** In the method for producing an optical semiconductor device according to claim 1 producing the optical semiconductor device by encapsulating the optical semiconductor element by an encapsulating layer in an A-stage state, wherein in the encapsulating layer producing step, the encapsulating layer in the A-stage state is produced;

in the encapsulating step, the optical semiconductor element is encapsulated by the encapsulating layer in the A-stage state; and
time from producing the encapsulating layer in the A-stage state in the encapsulating layer producing step to encapsulating the optical semiconductor element by the encapsulating layer in the A-stage state in the encapsulating step is 24 hours or less.

FIG. 1

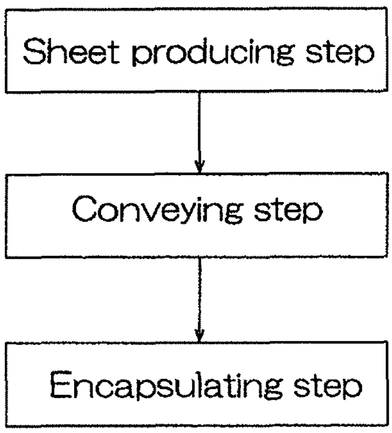
Sheet producing step
Conveying step
Encapsulating step

FIG. 2

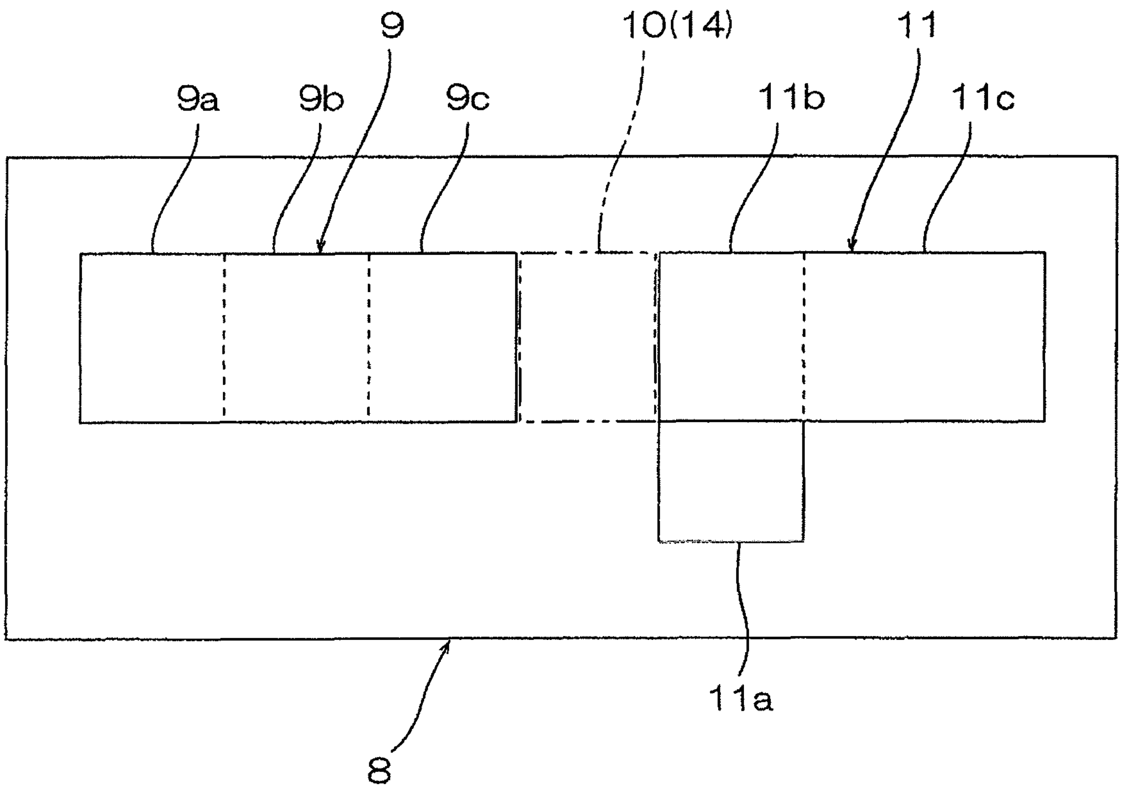
9
10(14)
11
9a
9b
9c
11b
11c
11a
8

FIG. 3A

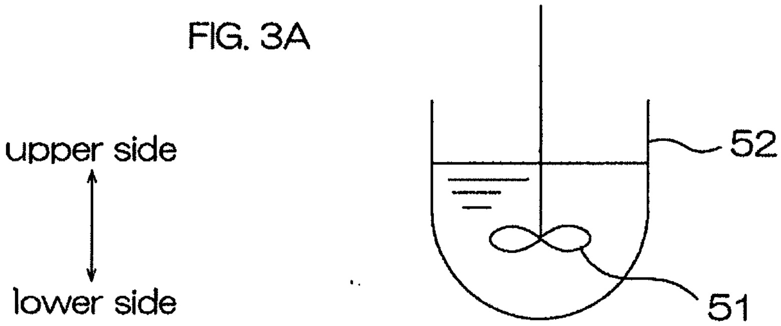


9a

FIG. 3B

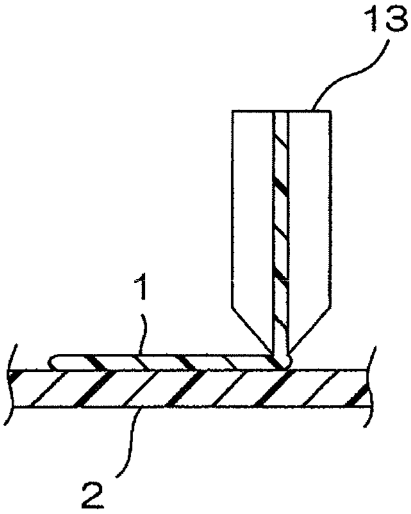


9b

FIG. 3C

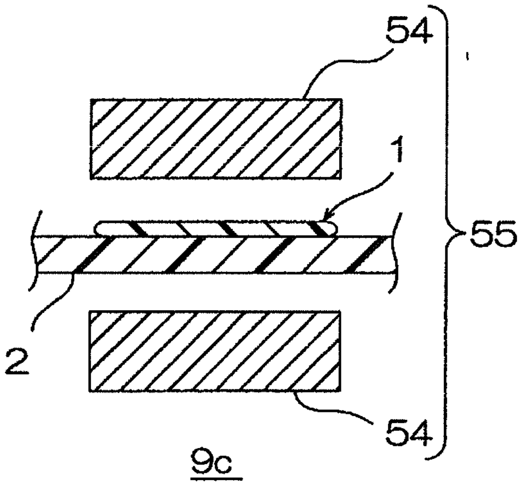


9c

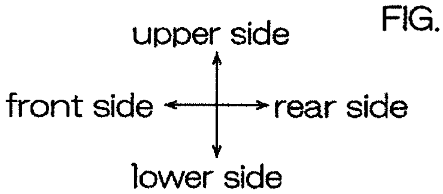


FIG. 4A

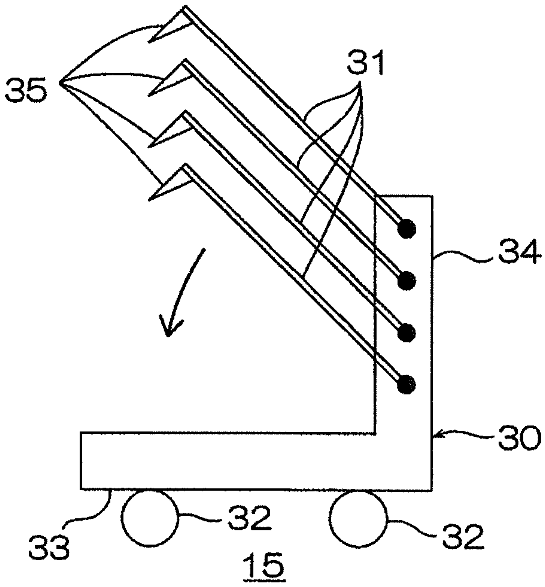


FIG. 4B

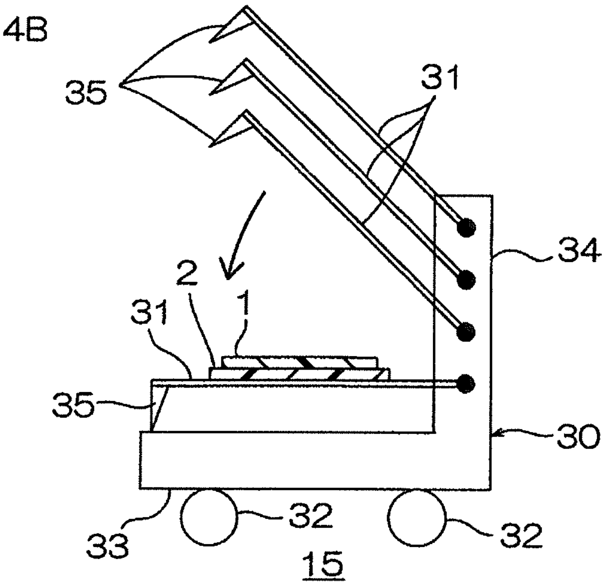


FIG. 4C

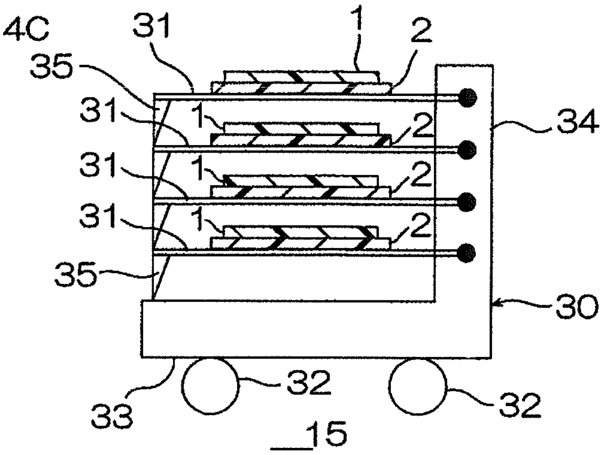

FIG. 5

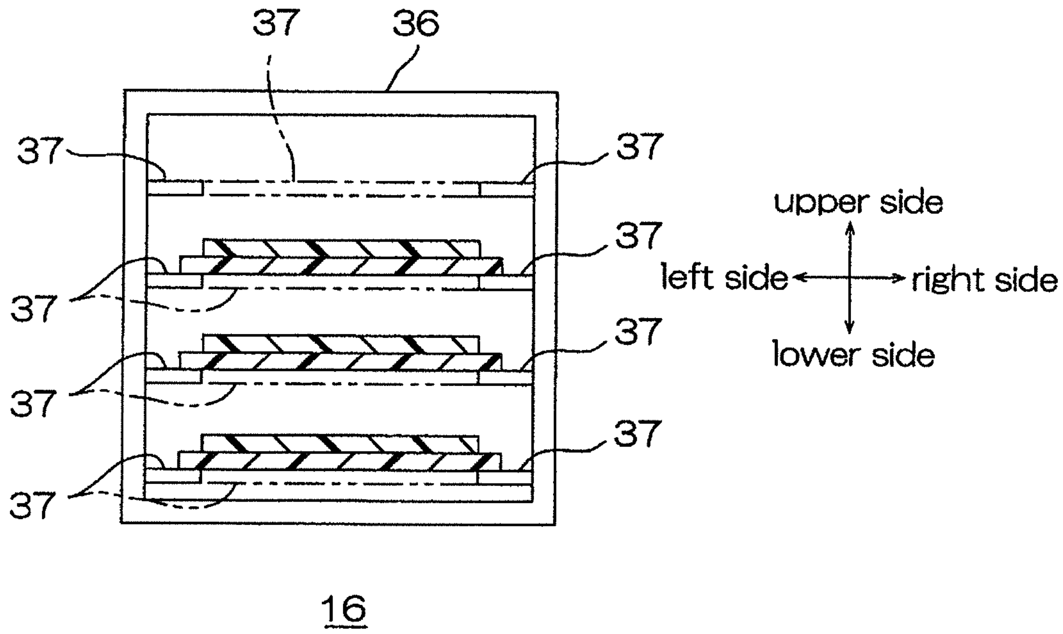
37
36
37
37
upper side
37
left side
right side
37
37
lower side
37
37
37
16

FIG. 6

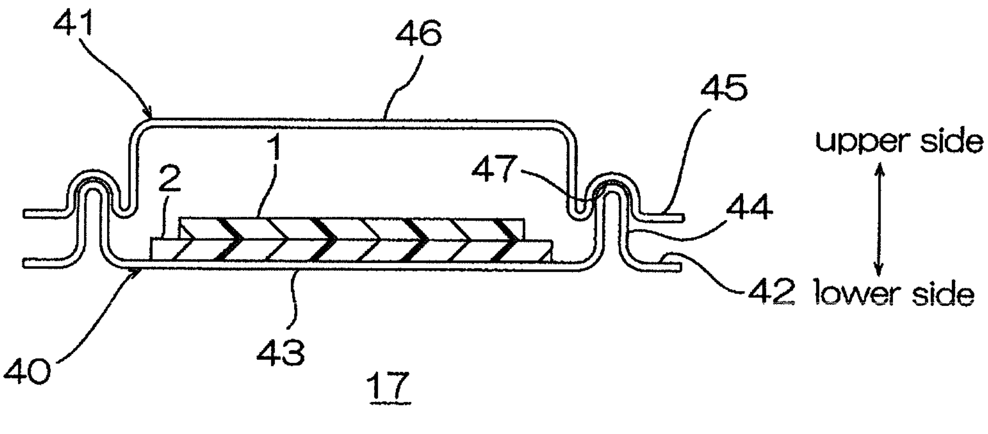
41
46
45
upper side
1
47
2
44
42
lower side
40
43
17

FIG. 7

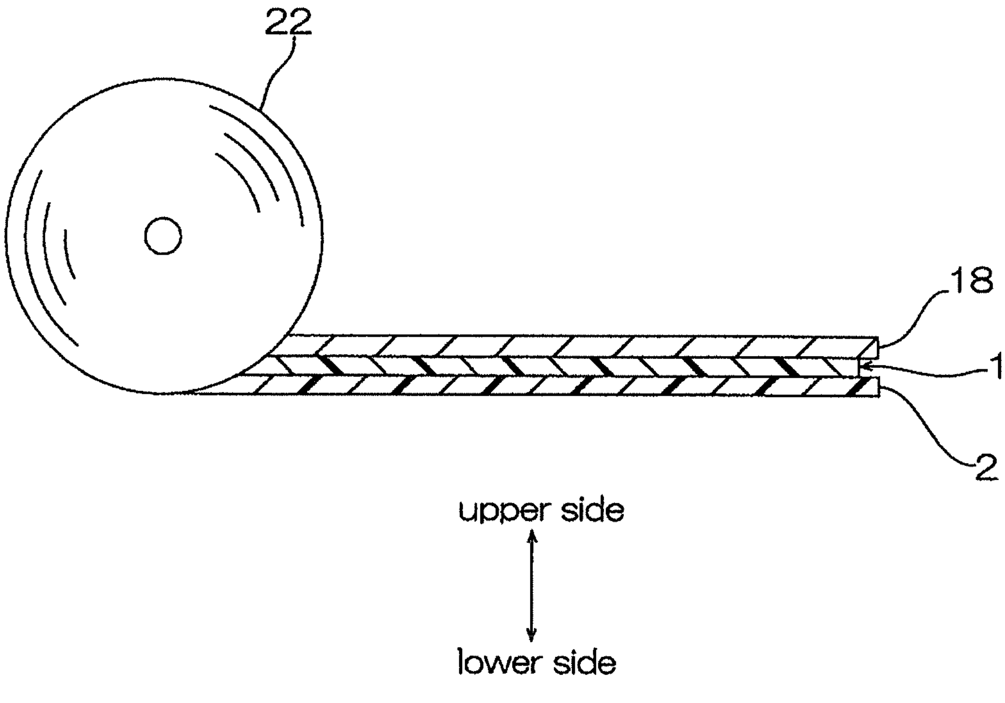

FIG. 8

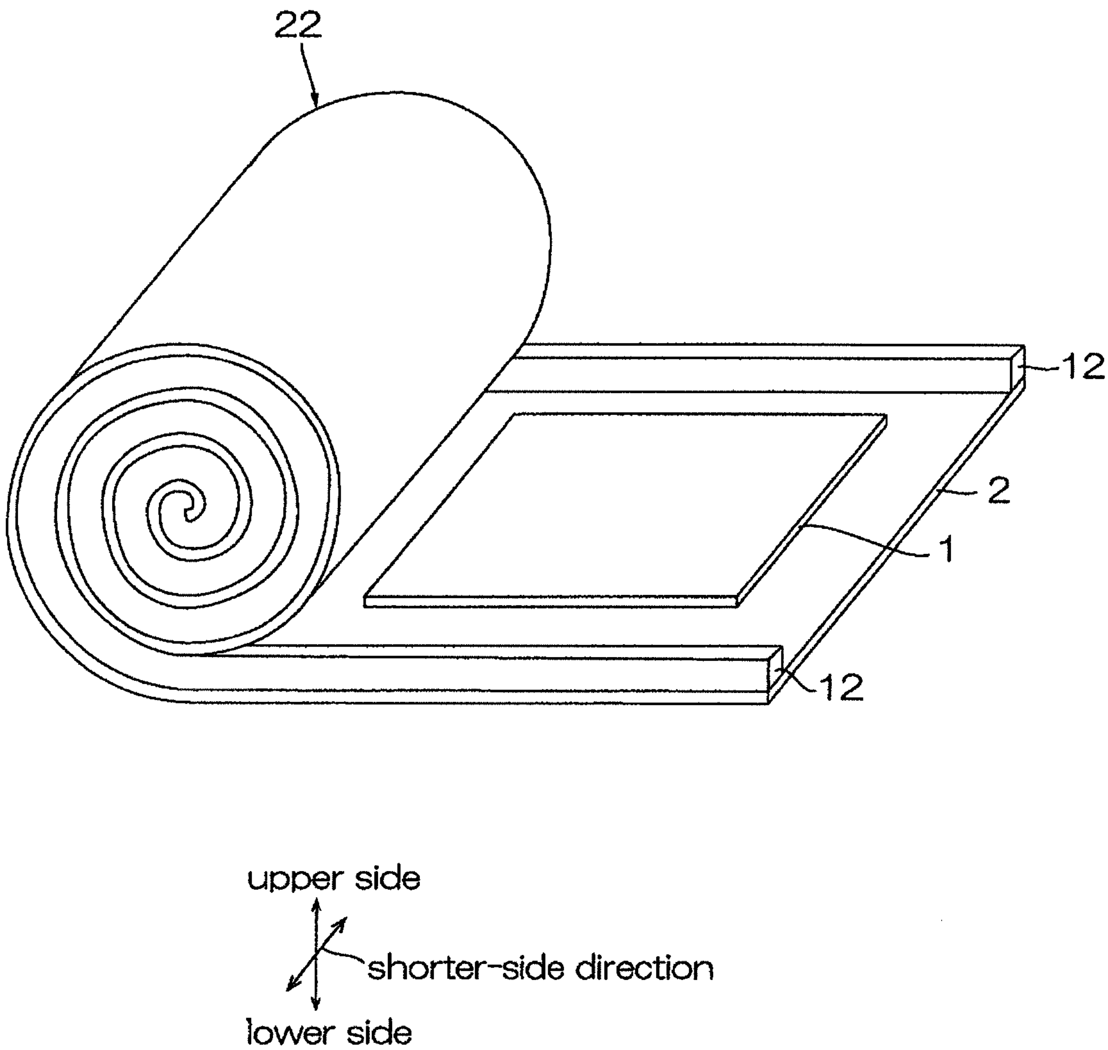

FIG. 9

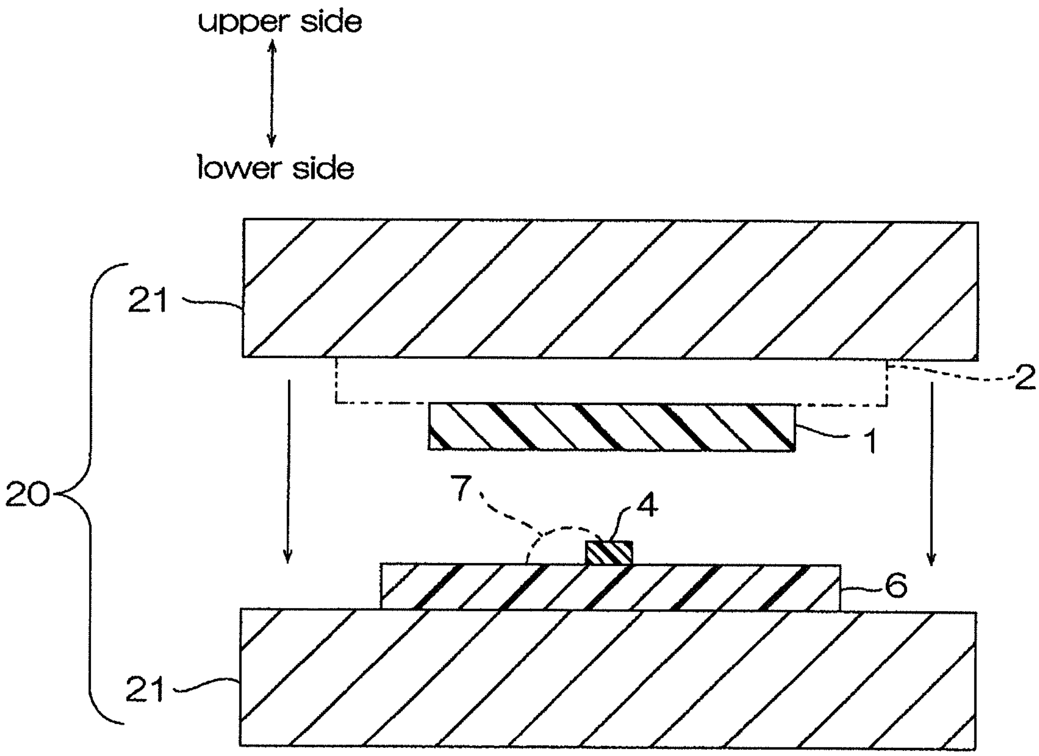
upper side
lower side
21
2
1
20
7
4
6
21

FIG. 10

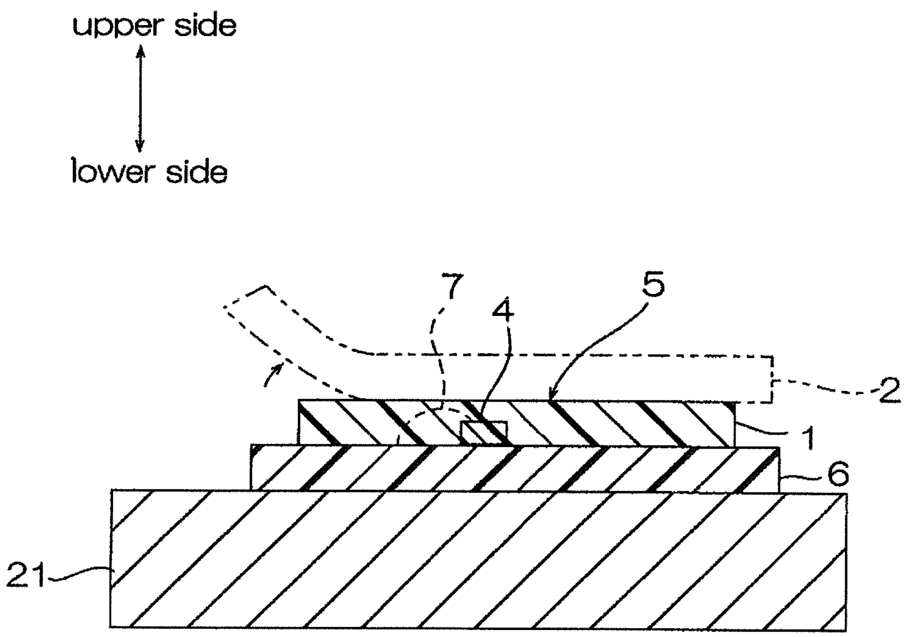
upper side
lower side
7
4
5
2
1
6
21

FIG. 11

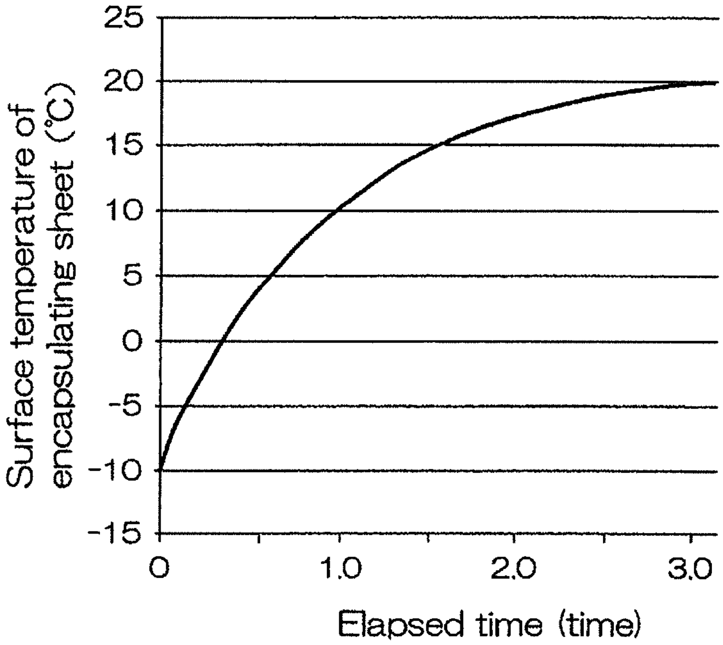
25
20
15
10
5
0
-5
-10
-15
Surface temperature of encapsulating sheet (℃)
0
1.0
2.0
3.0
Elapsed time (time)

FIG. 12

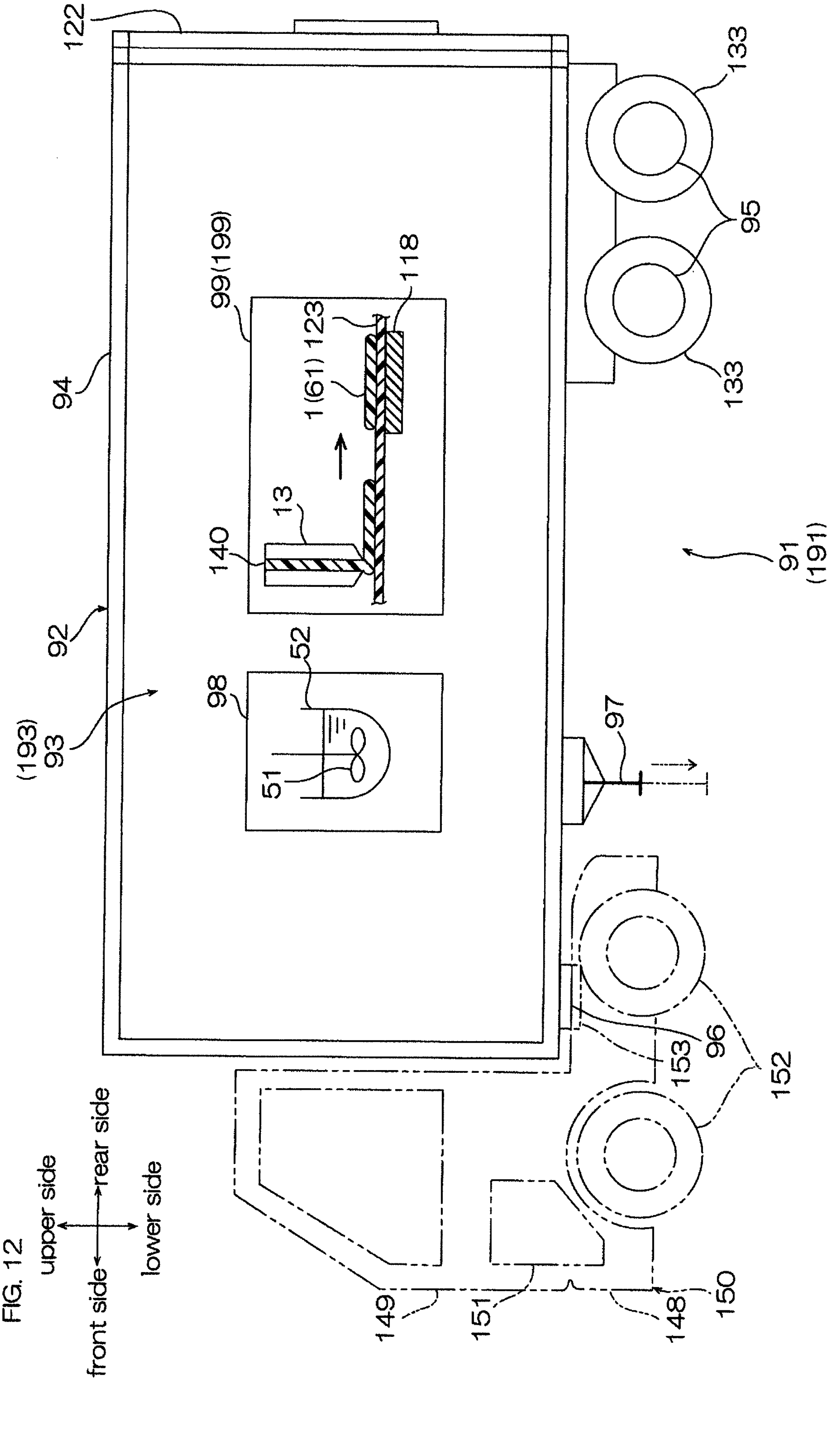
upper side
front side
rear side
lower side
122
133
95
133
94
99(199)
118
1(61) 123
13
140
92
52
98
(193)
93
51
97
91
(191)
96
153
152
149
151
148
150

FIG. 13

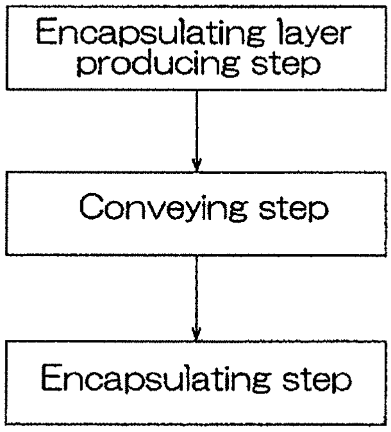
Encapsulating layer producing step
Conveying step
Encapsulating step

FIG. 14

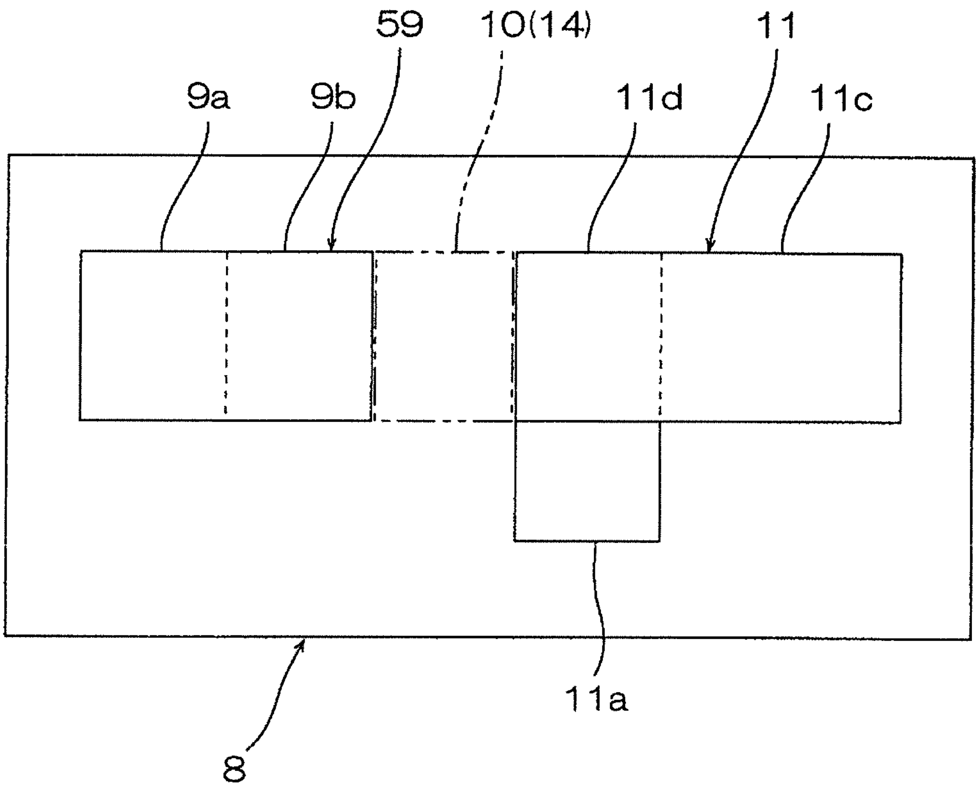
59
10(14)
11
9a
9b
11d
11c
11a
8

FIG. 15

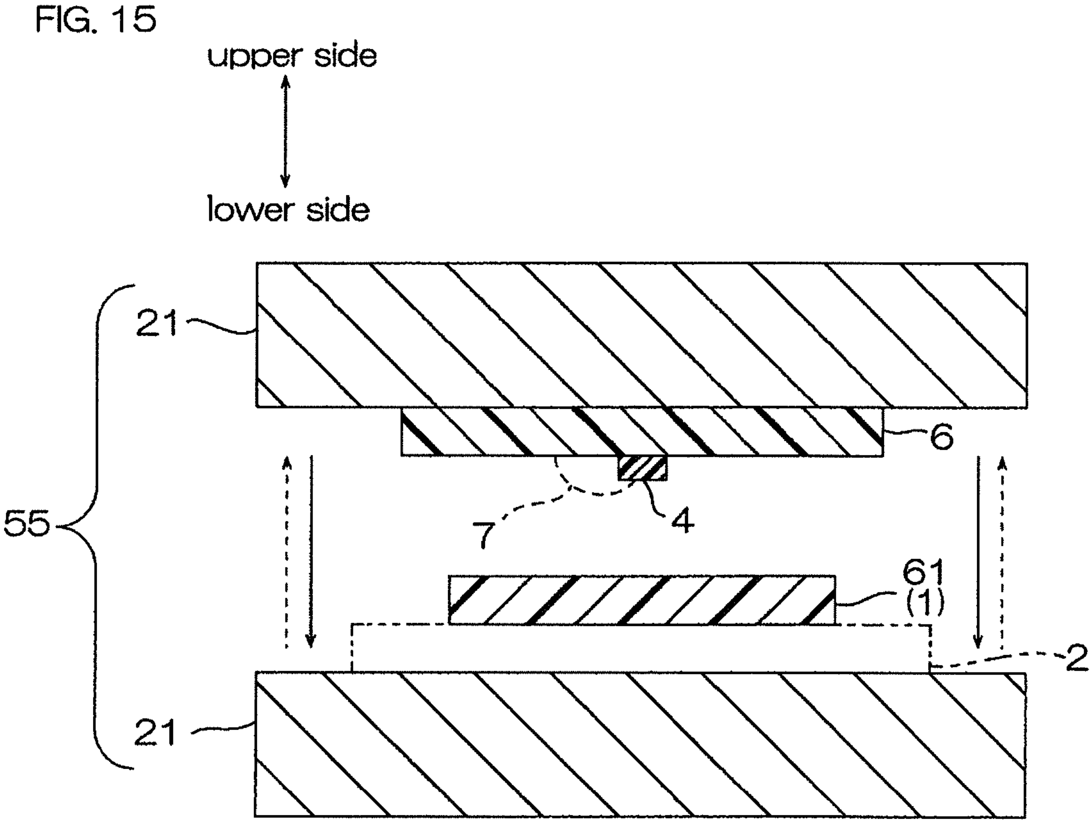
upper side
lower side
21
6
55
7
4
61
(1)
2
21

FIG. 16

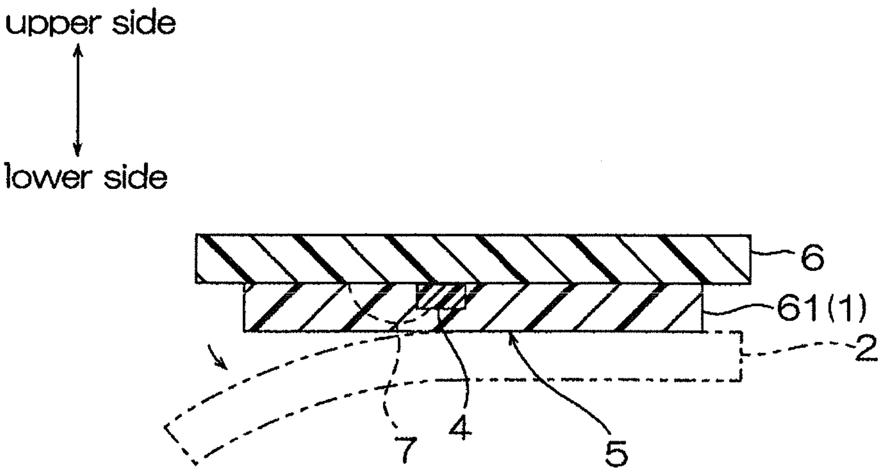
upper side
lower side
6
61(1)
2
7
4
5

**INTERNATIONAL SEARCH REPORT**

International application No.
PCT/JP2014/056101

A. CLASSIFICATION OF SUBJECT MATTER
*H01L33/56*(2010.01)i

According to International Patent Classification (IPC) or to both national classification and IPC

B. FIELDS SEARCHED

Minimum documentation searched (classification system followed by classification symbols)
H01L33/00-33/64

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2010-159411 A (Nitto Denko Corp.), 22 July 2010 (22.07.2010), entire text & US 2010/0148378 A1 & EP 2196503 A1 & KR 10-2010-0068211 A & CN 101747633 A | 1-5<br>1-6 |
| Y | JP 2001-110826 A (JSR Corp.), 20 April 2001 (20.04.2001), paragraphs [0002] to [0004] (Family: none) | 1-6 |
| Y | JP 2000-294836 A (Sharp Corp.), 20 October 2000 (20.10.2000), paragraphs [0004], [0040] (Family: none) | 1-6 |

[×] Further documents are listed in the continuation of Box C. [ ] See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 19 May, 2014 (19.05.14) | 03 June, 2014 (03.06.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2014/056101

C (Continuation). DOCUMENTS CONSIDERED TO BE RELEVANT

| Category* | Citation of document, with indication, where appropriate, of the relevant passages | Relevant to claim No. |
|---|---|---|
| Y | JP 6-91694 A (Nippon Zeon Co., Ltd.), 05 April 1994 (05.04.1994), paragraphs [0002], [0003] (Family: none) | 1-6 |
| Y | JP 2012-229317 A (Nitto Denko Corp.), 22 November 2012 (22.11.2012), paragraphs [0017], [0018], [0089] to [0105] (Family: none) | 6 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2011159874 A
- JP 2010265436 A